# EUROPEAN PATENT APPLICATION

(11) **EP 4 398 290 A1**
(43) Date of publication of application: **10.07.2024**
(21) Application number: 22863850.8
(22) Date of filing: 17.02.2022
(51) Int. Cl.: H01L 23/02, H01L 23/12, H01L 23/36, H01L 27/146, H04N 23/00, H04N 25/00

(54) **SEMICONDUCTOR DEVICE AND ELECTRONIC EQUIPMENT**

(30) Priority: 31.08.2021 JP 2021141678
(71) Applicant: Sony Semiconductor Solutions Corporation, Atsugi-shi, Kanagawa 243-0014 (JP)
(72) Inventor: MAKITA, Yoshihiro, Atsugi-shi, Kanagawa 243-0014 (JP); MURAYAMA, Toshihiro, Atsugi-shi, Kanagawa 243-0014 (JP); HATANO, Masaki, Atsugi-shi, Kanagawa 243-0014 (JP); TUKADA, Atsushi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/006371
(87) International publication number: WO 2023/032260

(57) **Abstract**

In a semiconductor device, a good heat dissipation property can be acquired using a simple configuration, and adjustment of tilting of the semiconductor element can be easily performed with high accuracy.

A semiconductor device includes: a substrate; a first metal part configured to be disposed on one plate face side of the substrate; a semiconductor element configured to be disposed in a state of being fixed to the first metal part and electrically connected to the substrate; a second metal part configured to be disposed on the other plate face side of the substrate; and a connection part that is a metal part connecting the first metal part and the second metal part to each other.

## Description

### [Technical Field]

The present disclosure relates to a semiconductor device and an electronic device.

### [Background Art]

In a semiconductor device having a package structure in which a semiconductor element such as a solid-state imaging element or the like is mounted, from a point of view of acquiring desired characteristics by maintaining a good operation state of the device, it is important to dissipate heat generated from the semiconductor element that becomes a heating body. In addition, in a manufacturing process of an electronic device in which a semiconductor device including a solid-state imaging element is mounted, inclination, or tilting, of an imaging face of the solid-state imaging element is adjusted such that the imaging face of the solid-state imaging element is vertical to an optical axis of an optical system configured using a lens and the like.

For example, in PTL 1, as a package structure, a configuration including a container made of a resin having a concave part for mounting a solid-state imaging element, a lead having exposed parts inside the concave part of the container and outside the container, and an island, which includes an island main body disposed inside the bottom of the concave part of the container, formed using a copper alloy or the like is disclosed. In such a configuration, in order to improve a heat dissipation property, the island is formed to include a plurality of heat dissipation parts exposed to the surface of an outer edge part of the container as extending parts from the island main body.

In PTL 2, a configuration in which a plurality of contact parts used for positioning for determining the position of the solid-state imaging element with respect to a camera body are disposed in a main body of the package housing the solid-state imaging element is disclosed. The contact parts for positioning are disposed by bonding a predetermined member to the main body of the package.

In the configuration disclosed in PTL 2, the main body of the package is configured to include a bottom plate to which a solid-state imaging element is attached, an embedding member embedded in the bottom plate, and an attachment plate bonded to a side of the bottom plate that is opposite to the attachment side of the solid-state imaging element. Both the embedding member and the attachment plate are formed from materials having high thermal conductivity and are thermally coupled and thus have a function of dissipating heat generated from the solid-state imaging element.

### [Citation List]

### [Patent Literature]

[PTL 1]
   JP 2014-72830A
[PTL 2]
   JP 2009-232159A

### [Summary]

### [Technical Problem]

Although the configuration disclosed in PTL 1 has a plurality of heat dissipation parts exposed to the surface side of the container in the island, these heat dissipation parts are parts that extend from the island main body and are exposed to a limited part in the outer edge part of the container. For this reason, there is a problem that it is difficult to sufficiently acquire a heat dissipation property for the surface side of the container. In addition, according to the configuration disclosed in PTL 1, it is necessary to bend the island and the like for positioning the heat dissipation parts of the island at a predetermined place in the container, and thus there is a problem that the manufacturing process and the facility become complicated.

Furthermore, according to the configuration disclosed in PTL 2, in a process for disposing contact parts for positioning that become parts for tilting adjustment of a solid-state imaging element, there is a problem that it is difficult to bond a predetermined member to the main body of the package, and a long time and many processes are required. In addition, the configuration disclosed in PTL 2 is a configuration in which a lid body such as a glass plate or the like is disposed on the surface side of the solid-state imaging element through a frame plate formed using a lead frame, a resin, and the like on the bottom plate, and thus there is a problem in that it is difficult to acquire a sufficient heat dissipation property.

An object of the present technology is to provide a semiconductor device and an electronic device capable of acquiring a good heat dissipation property using a simple configuration and easily adjusting tilting of a semiconductor element with high accuracy.

### [Solution to Problem]

According to the present technology, there is provided a semiconductor device including: a substrate; a first metal part configured to be disposed on one plate face side of the substrate; a semiconductor element configured to be disposed to be fixed to the first metal part and electrically connected to the substrate; a second metal part configured to be disposed on the other plate face side of the substrate; and a connection part that is a metal part connecting the first metal part and the second metal part to each other.

According to another aspect of the semiconductor device according to the present technology, in the semiconductor device described above, the connection part is integrally formed with the second metal part.

According to another aspect of the semiconductor device according to the present technology, in the semiconductor device described above, the first metal part and the second metal part are formed using the same metal material.

According to another aspect of the semiconductor device according to the present technology, in the semiconductor device described above, the second metal part is configured by a member of a frame shape.

According to another aspect of the semiconductor device according to the present technology, in the semiconductor device described above, the second metal part has an opening part exposing the semiconductor element, and the semiconductor device further includes a transparent member configured to be disposed to close the opening part on a side opposite to the substrate side with respect to the second metal part and form a cavity that is a space of a closed shape together with the substrate, the first metal part, and the second metal part.

According to another aspect of the semiconductor device according to the present technology, the semiconductor device described above further includes a resin part configured to be disposed on a side opposite to the substrate side with respect to the second metal part, be formed using a resin as a material, and configure a member of a frame shape together with the second metal part.

According to another aspect of the semiconductor device according to the present technology, in the semiconductor device described above, the resin part has an opening part exposing the semiconductor element, and the semiconductor device further includes a transparent member configured to be disposed to close the opening part on a side opposite to the substrate side with respect to the resin part and form a cavity that is a space of a closed shape together with the substrate, the first metal part, the second metal part, and the resin part.

According to another aspect of the semiconductor device according to the present technology, the semiconductor device described above further includes a third metal part configured to be disposed on a side opposite to the second metal part side with respect to the resin part and configure a member of a frame shape together with the second metal part and the resin part.

According to another aspect of the semiconductor device according to the present technology, the semiconductor device described above further includes a second connection part that is a metal part connecting the second metal part and the third metal part to each other.

According to another aspect of the semiconductor device according to the present technology, in the semiconductor device described above, the connection part has a protrusion part that is integrally formed with the first metal part, goes through the substrate, and protrudes from the second metal part to a side opposite to the substrate side.

According to the present technology, there is provided an electronic device that includes a semiconductor device including: a substrate; a first metal part configured to be disposed on one plate face side of the substrate; a semiconductor element configured to be disposed to be fixed to the first metal part and electrically connected to the substrate; a second metal part configured to be disposed on the other plate face side of the substrate; and a connection part that is a metal part connecting the first metal part and the second metal part to each other.

### [Brief Description of Drawings]

[Fig. 1]

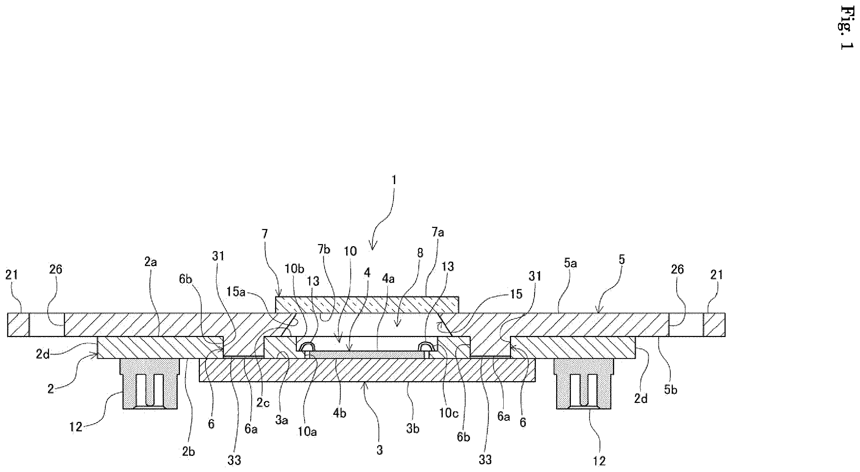

   Fig. 1 is a cross-sectional view illustrating the configuration of a solid-state imaging device according to a first embodiment of the present technology.
[Fig. 2]

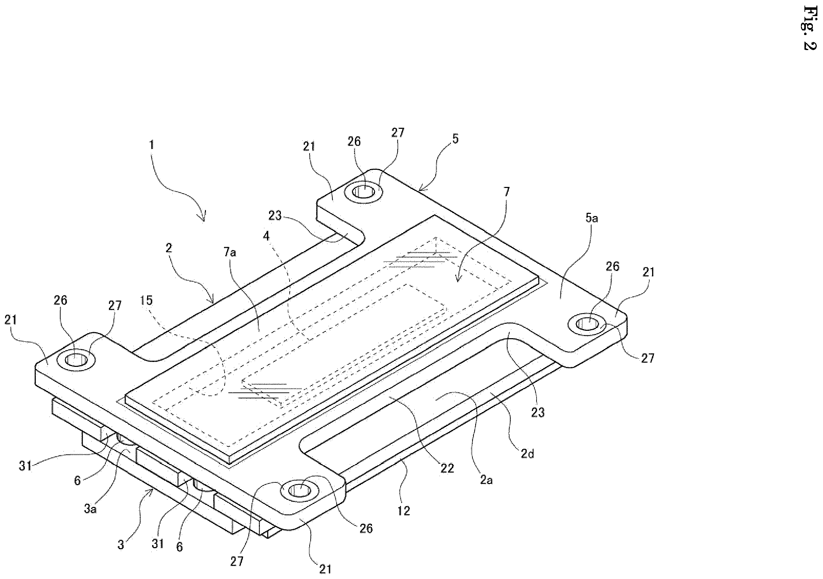

   Fig. 2 is a top perspective view illustrating the configuration of the solid-state imaging device according to the first embodiment of the present technology.
[Fig. 3]

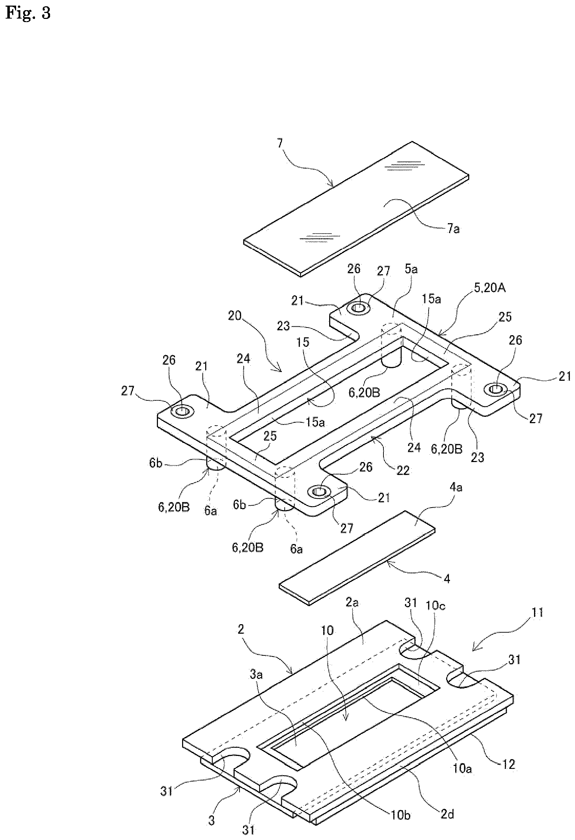

   Fig. 3 is an exploded perspective view illustrating the configuration of the solid-state imaging device according to the first embodiment of the present technology.
[Fig. 4]

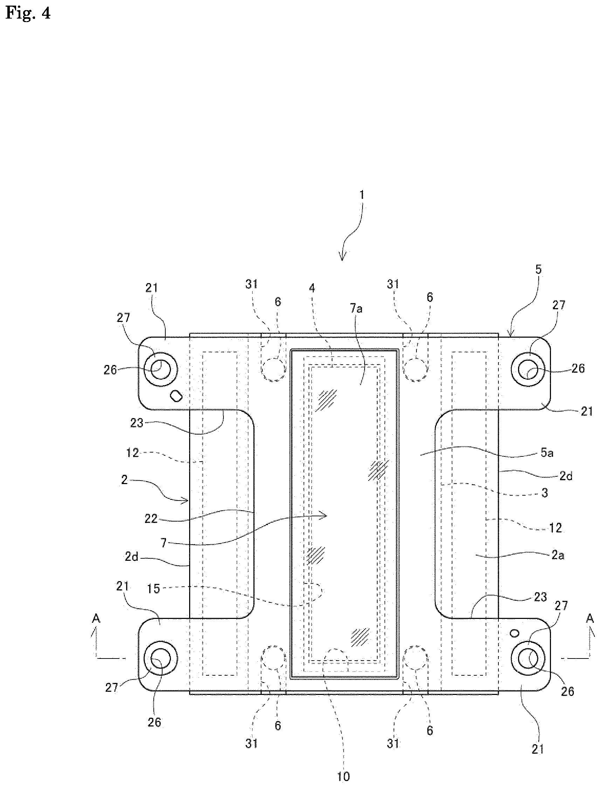

   Fig. 4 is a plan view illustrating the configuration of the solid-state imaging device according to the first embodiment of the present technology.
[Fig. 5]

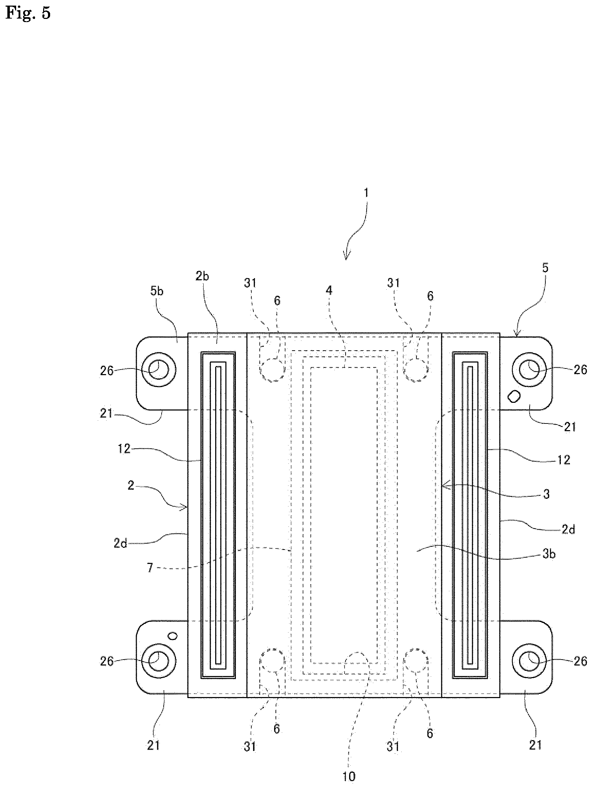

   Fig. 5 is a bottom view illustrating the configuration of the solid-state imaging device according to the first embodiment of the present technology.
[Fig. 6]

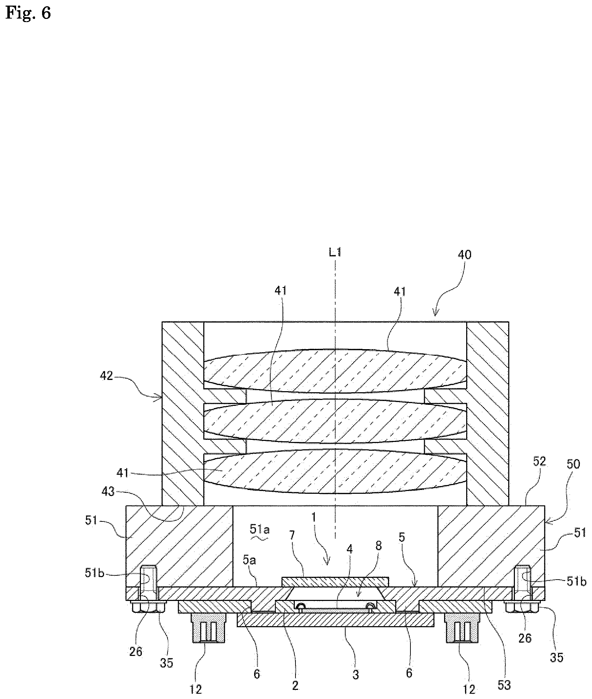

   Fig. 6 is a diagram illustrating an example of attachment of the solid-state imaging device according to the first embodiment of the present technology.
[Fig. 7]

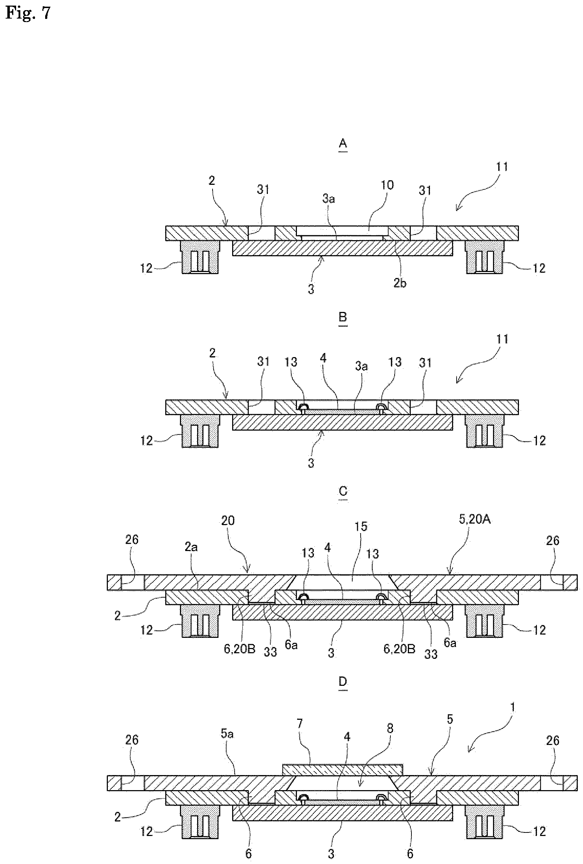

   Fig. 7 is an explanatory diagram of a method of manufacturing the solid-state imaging device according to the first embodiment of the present technology.
[Fig. 8]

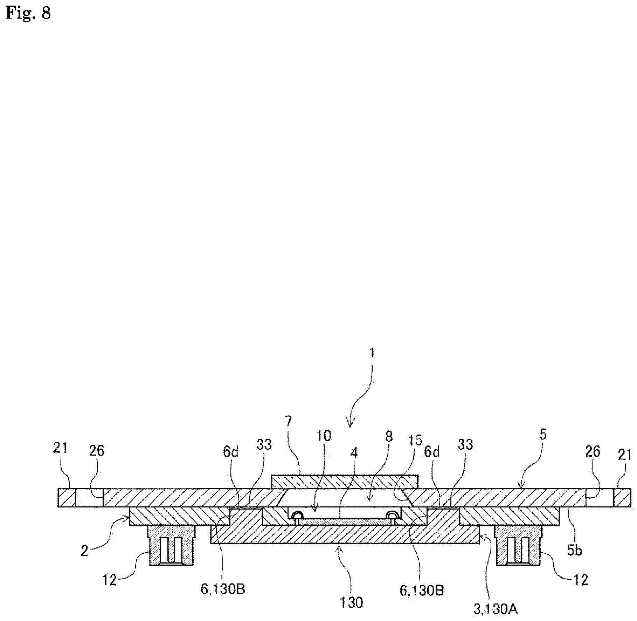

   Fig. 8 is a cross-sectional view illustrating the configuration of a first modified example of the solid-state imaging device according to the first embodiment of the present technology.
[Fig. 9]

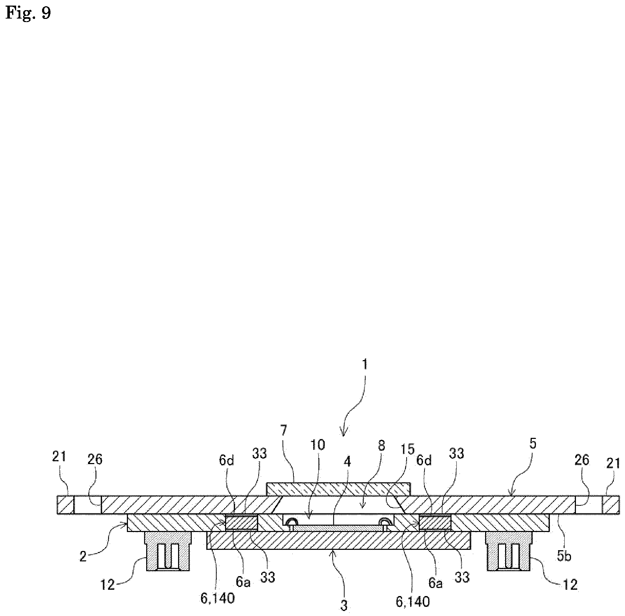

   Fig. 9 is a cross-sectional view illustrating the configuration of a second modified example of the solid-state imaging device according to the first embodiment of the present technology.
[Fig. 10]

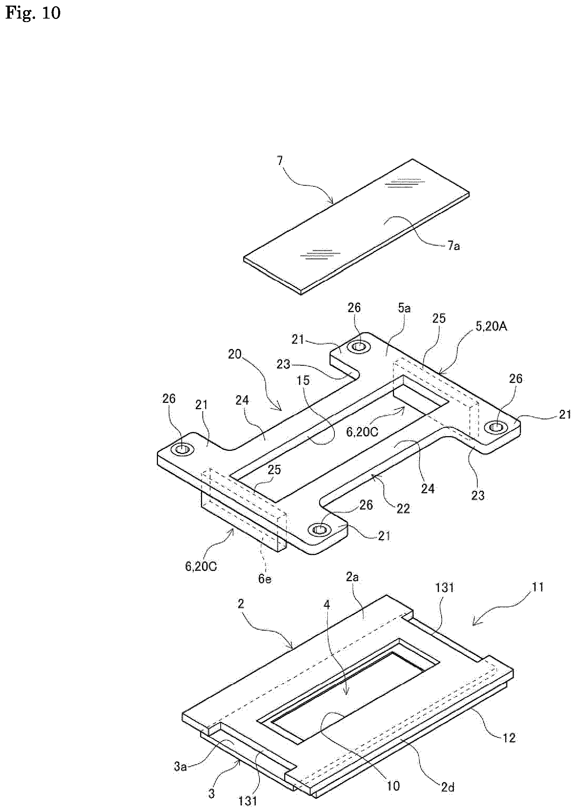

   Fig. 10 is an exploded perspective view illustrating the configuration of a third modified example of the solid-state imaging device according to the first embodiment of the present technology.
[Fig. 11]

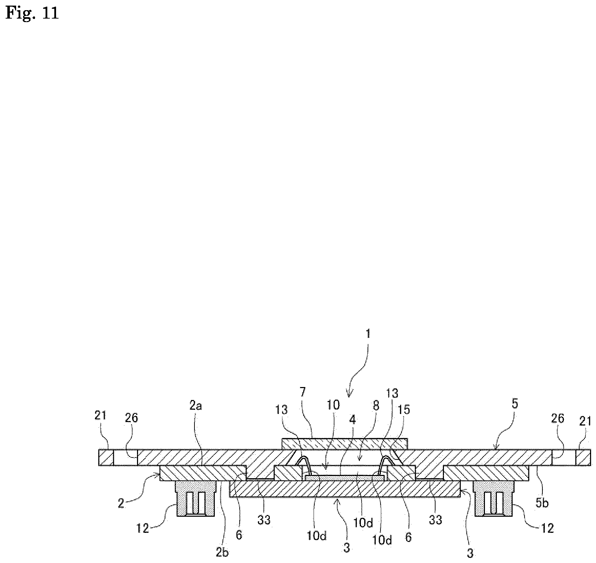

   Fig. 11 is a divided cross-sectional view illustrating the configuration of a fourth modified example of the solid-state imaging device according to the first embodiment of the present technology.
[Fig. 12]

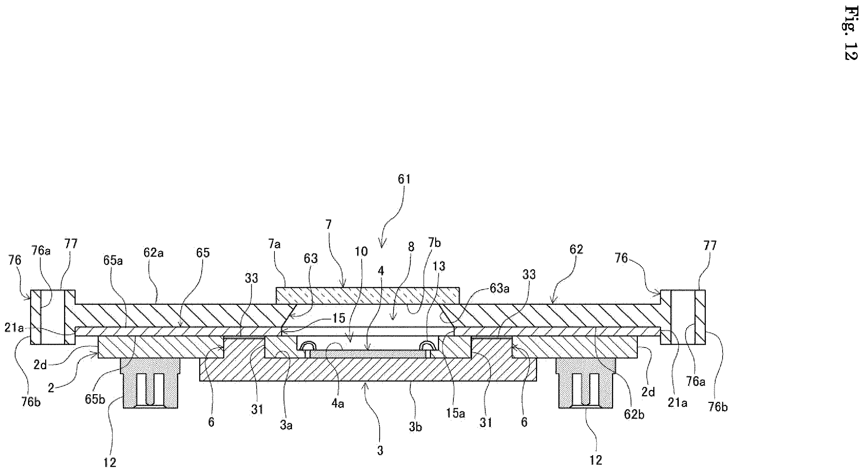

   Fig. 12 is a cross-sectional view illustrating the configuration of a solid-state imaging device according to a second embodiment of the present technology.
[Fig. 13]

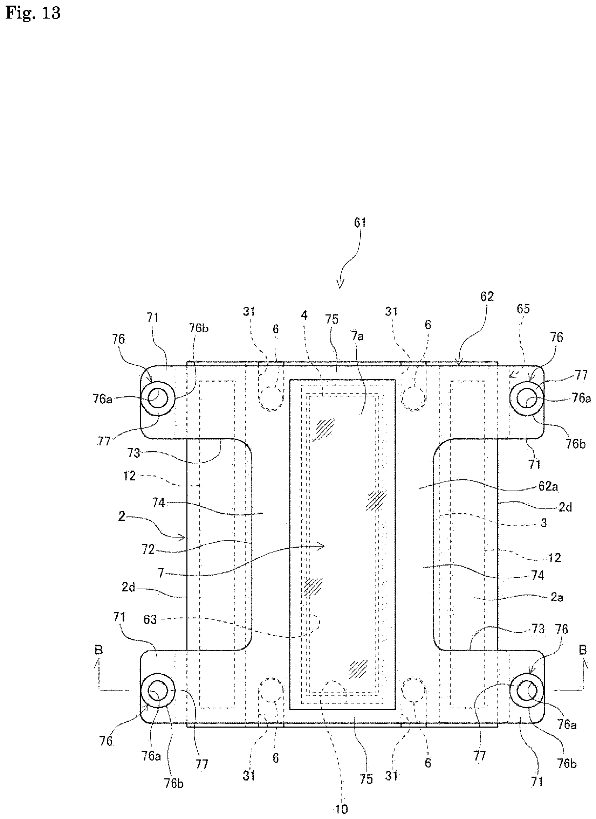

   Fig. 13 is a plan view illustrating the configuration of the solid-state imaging device according to the second embodiment of the present technology.
[Fig. 14]

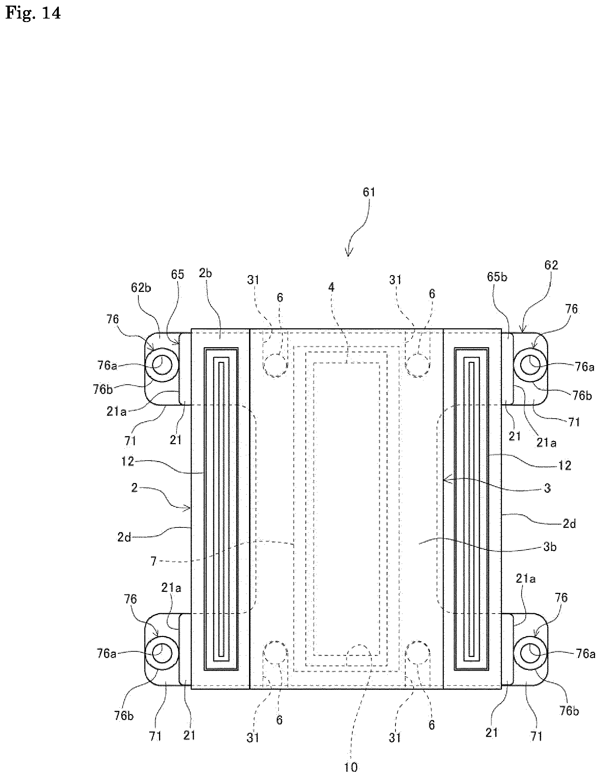

   Fig. 14 is a bottom view illustrating the configuration of the solid-state imaging device according to the second embodiment of the present technology.
[Fig. 15]

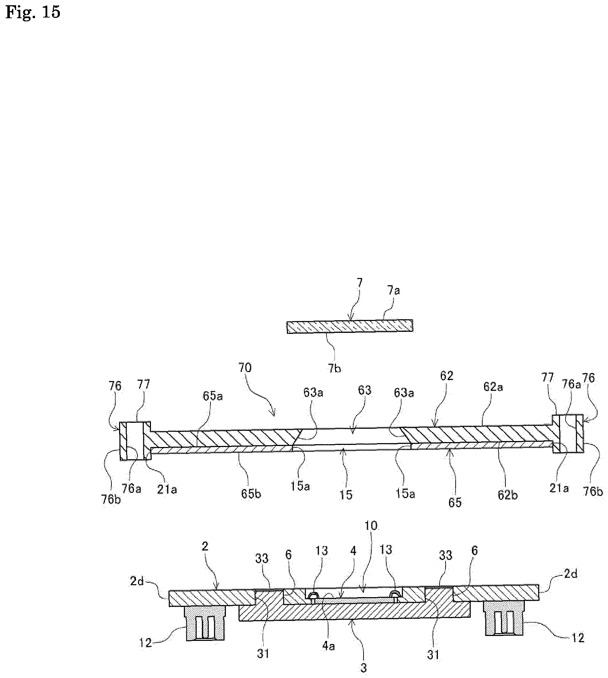

   Fig. 15 is an exploded side face cross-sectional view illustrating the configuration of the solid-state imaging device according to the second embodiment of the present technology.
[Fig. 16]

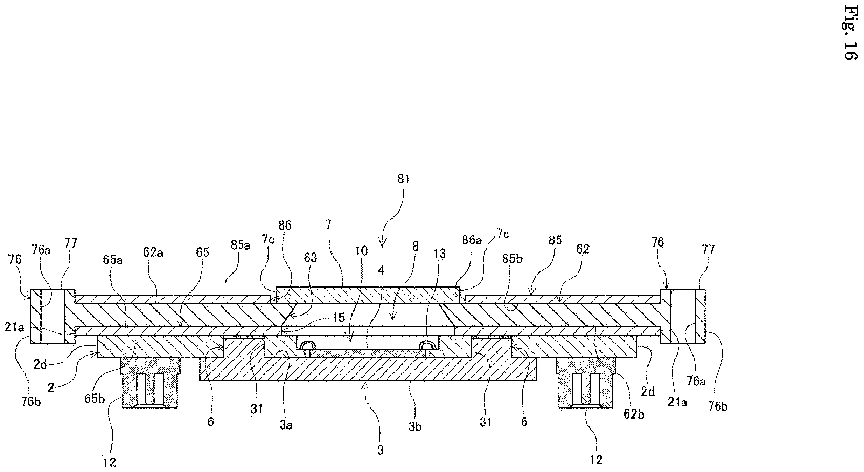

   Fig. 16 is a cross-sectional view illustrating the configuration of a solid-state imaging device according to a third embodiment of the present technology.
[Fig. 17]

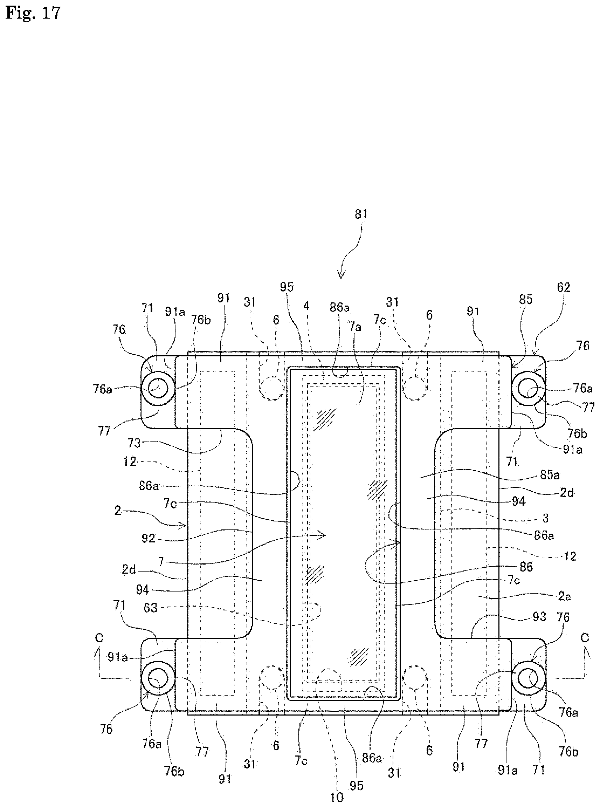

   Fig. 17 is a plan view illustrating the configuration of the solid-state imaging device according to the third embodiment of the present technology.
[Fig. 18]

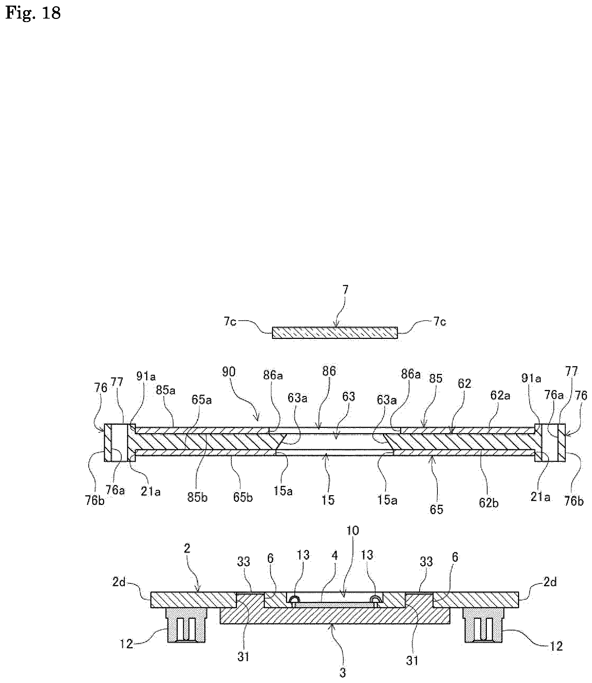

   Fig. 18 is an exploded side face cross-sectional view illustrating the configuration of the solid-state imaging device according to the third embodiment of the present technology.
[Fig. 19]

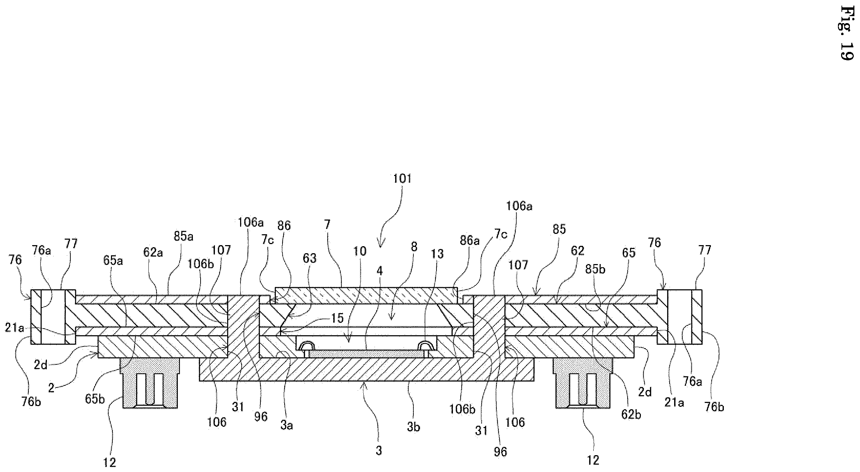

   Fig. 19 is a cross-sectional view illustrating the configuration of a solid-state imaging device according to a fourth embodiment of the present technology.
[Fig. 20]

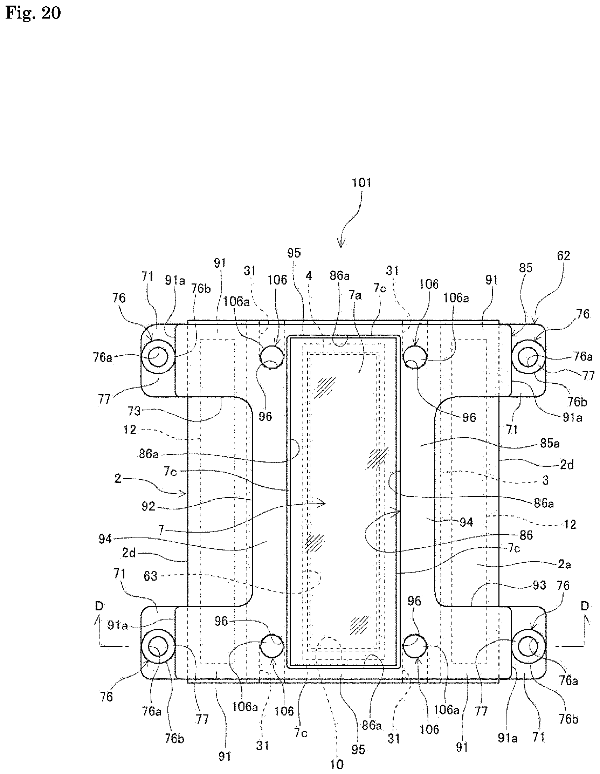

   Fig. 20 is a plan view illustrating the configuration of the solid-state imaging device according to the fourth embodiment of the present technology.
[Fig. 21]

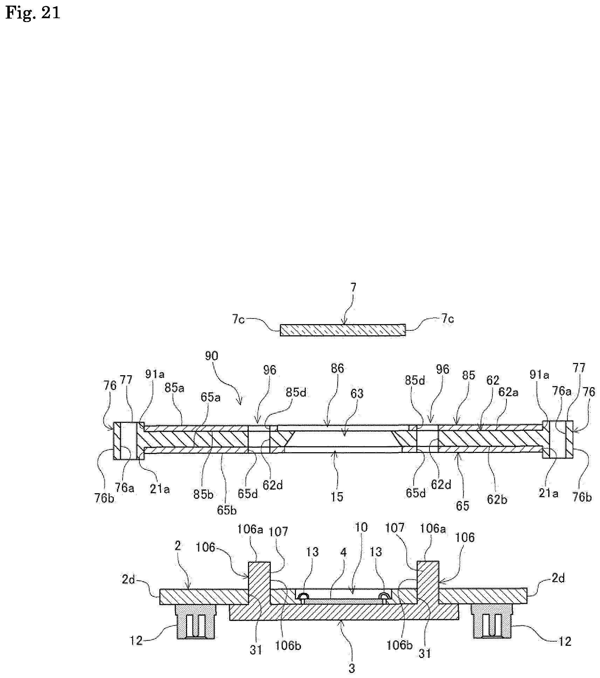

   Fig. 21 is an exploded side face cross-sectional view illustrating the configuration of the solid-state imaging device according to the fourth embodiment of the present technology.
[Fig. 22]

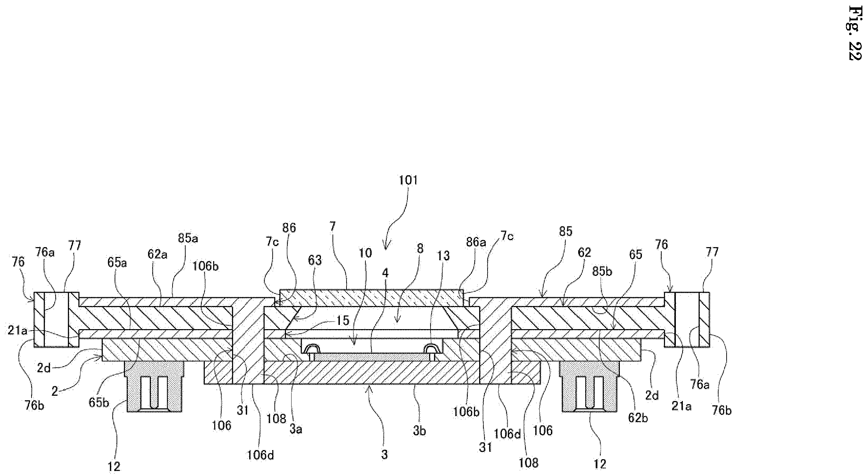

   Fig. 22 is a cross-sectional view illustrating the configuration of a modified example of the solid-state imaging device according to the fourth embodiment of the present technology.
[Fig. 23]

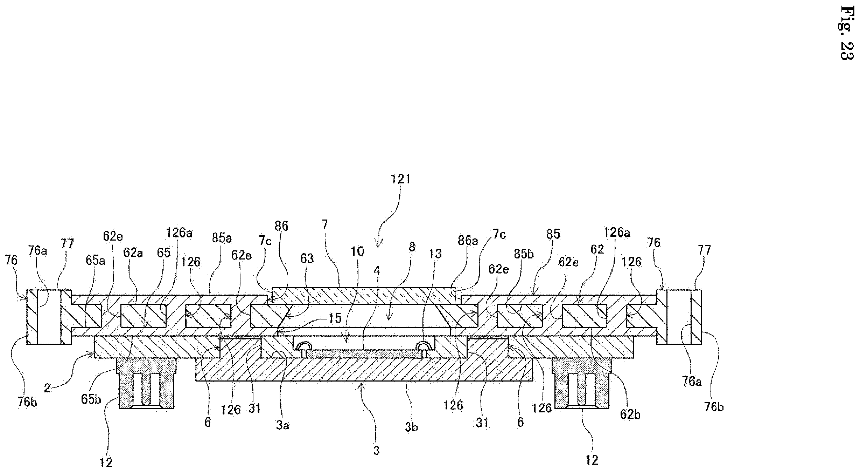

   Fig. 23 is a cross-sectional view illustrating the configuration of a solid-state imaging device according to a fifth embodiment of the present technology.
[Fig. 24]

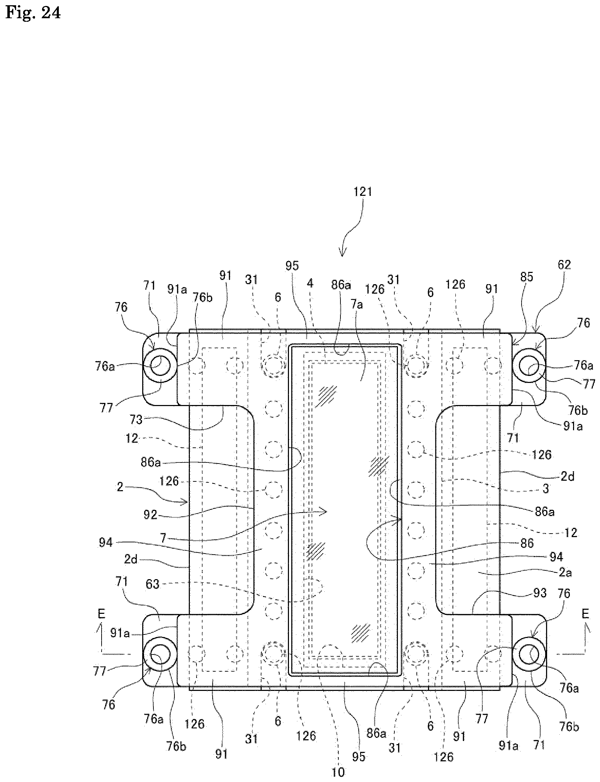

   Fig. 24 is a plan view illustrating the configuration of the solid-state imaging device according to the fifth embodiment of the present technology.
[Fig. 25]

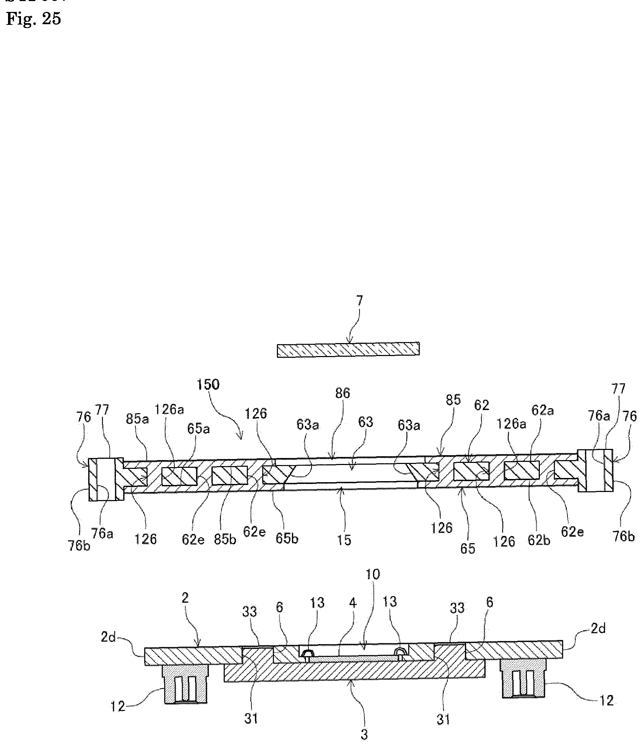

   Fig. 25 is an exploded side face cross-sectional view illustrating the configuration of the solid-state imaging device according to the fifth embodiment of the present technology.
[Fig. 26]

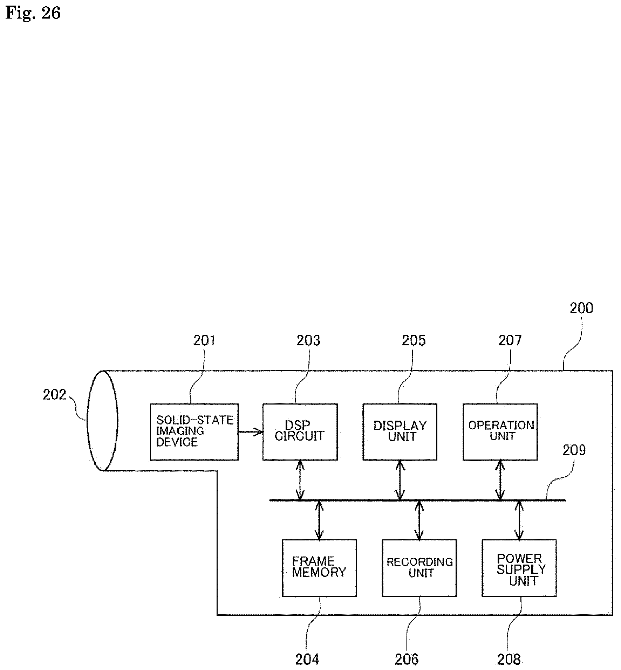

   Fig. 26 is a block diagram illustrating a configuration example of an electronic device including a solid-state imaging device according to one embodiment of the present technology.

### [Description of Embodiments]

The present technology achieves acquisition of a good heat dissipation property and easy adjustment of tilting of a semiconductor element by using a configuration in which metal parts are disposed on both plate face sides of a substrate, and such metal parts are thermally connected.

Modes for carrying out the present technology (hereinafter referred to as embodiments) will be described below with reference to the drawings. In embodiments to be described below, as a semiconductor device, a solid-state imaging device including a solid-state imaging element that is one example of a semiconductor element will be described as an example. The description of embodiments will be made in the following order.
1. Configuration Example of Solid-state Imaging Device According to First Embodiment
2. Method of Manufacturing Solid-state Imaging Device According to First Embodiment
3. Modified Example of Solid-state Imaging Device According to First Embodiment
4. Configuration Example of Solid-state Imaging Device According to Second Embodiment
5. Configuration Example of Solid-state Imaging Device According to Third Embodiment
6. Configuration Example of Solid-state Imaging Device According to Fourth Embodiment
7. Configuration Example of Solid-state Imaging Device According to Fifth Embodiment
8. Configuration Example of Electronic device

### <1. Configuration Example of Solid-state Imaging Device According to First Embodiment>

A configuration example of a solid-state imaging device 1 according to a first embodiment of the present technology will be described with reference to Figs. 1 to 5. Fig. 1 is a cross-sectional view corresponding to an A - A position illustrated in Fig. 4. A vertical direction in Fig. 1 is assumed to be a vertical direction in the solid-state imaging device 1.

As illustrated in Figs. 1 to 5, the solid-state imaging device 1 includes a frame substrate 2 as a substrate, a lower metal part 3 as a first metal part, an image sensor 4 as a solid-state imaging element, an upper metal part 5 as a second metal part, a connection metal part 6 as a connection part, and a glass 7 as a light transmitting member. The solid-state imaging device 1 forms an integrated package structure forming a cavity 8 that is a closed space on the image sensor 4 by surrounding the periphery of the image sensor 4 mounted on the lower metal part 3 using the frame substrate 2 and the upper metal part 5 and covering an upper side of the image sensor 4 using the glass 7 disposed on the upper metal part 5 (see Fig. 1).

The frame substrate 2 is an interposer substrate having an approximately rectangular plate shape as its external shape and has a front face 2a that is an upper face and a rear face 2b that is a plate face on a side opposite to the front face 2a and is a lower face. Both the front face 2a and the rear face 2b are faces having a horizontal shape. The frame substrate 2, for example, is a ceramic substrate formed using a ceramic such as alumina (Al2O3), aluminum nitride (AlN), silicon nitride (Si3N4), or the like as its material in which a wiring layer, electrodes, predetermined circuits, and the like are disposed in a base formed using a material such as a ceramic or the like. Here, the frame substrate 2, for example, may be a substrate of another type such as an organic substrate formed from an organic material such as a glass epoxy resin that is one type of fiber-reinforced plastic or the like.

The frame substrate 2 has a substrate opening part 10 used for causing light received by the image sensor 4 to pass through it. The substrate opening part 10 is a hole part that goes through the frame substrate 2 in a plate thickness direction (a vertical direction) and has an opening shape of a rectangular shape corresponding to an outer shape of the image sensor 4. The substrate opening part 10 has an opening size that is slightly larger than the outer size of the image sensor 4 and is formed such that the entire image sensor 4 enters the inside of the substrate opening part 10 in the plan view.

The substrate opening part 10 is formed in a rectangular shape having a longitudinal direction of the frame substrate 2 as its longitudinal direction at the center part of the frame substrate 2 in a transverse direction. The frame substrate 2 has an outer form of a frame shape by having the substrate opening part 10. A horizontal direction and a vertical direction in Fig. 4 respectively correspond to the transverse direction and the longitudinal direction of the frame substrate 2. Hereinafter, the transverse direction and the longitudinal direction of the frame substrate 2 may be referred to also as a horizontal direction and a forward/backward direction. The solid-state imaging device 1 is configured to be symmetric in each direction of the horizontal direction and the forward/backward direction.

The substrate opening part 10 has a level-difference shape in which an opening area of an upper side (the front face 2a side) is wider than a lower side (the rear face 2b side). As faces forming the substrate opening part 10, the frame substrate 2 has lower side faces 10a of four sides forming a part of a lower side of the substrate opening part 10, upper side faces 10b of four sides forming a part of an upper side of the substrate opening part 10, and a level-difference face 10c of a horizontal shape that joins such side faces. In other words, the substrate opening part 10 causes the part of the lower side formed by the lower side faces 10a of the four sides to open to the rear face 2b and causes the part of the upper side formed by the upper side faces 10b of the four sides to open to the front face 2a.

In this embodiment, in a thickness direction of the frame substrate 2, the size of the lower side face 10a is smaller than the size of the upper side face 10b. Here, the magnitude relation of the sizes of both faces in the thickness direction of the frame substrate 2 is not particularly limited. The level-difference face 10c is formed over the entire circumference of the substrate opening part 10, and a part of an upper side of the substrate opening part 10 is formed to be much larger than a part of a lower side.

The lower metal part 3 is a metal part disposed on the rear face 2b side that is one plate face of the frame substrate 2. The lower metal part 3 is disposed by fixing a plate shape member made of a metal having an approximately rectangular plate shape as its outer shape on the rear face 2b side of the frame substrate 2.

A plate shaped member forming the lower metal part 3 is fixed to the frame substrate 2, for example through bonding using a die bonding agent that is a bonding agent of a resin system, a joint using brazing, or the like. As the bonding agent fixing the lower metal part 3 to the frame substrate 2, for example, an epoxy resin-based bonding agent, an acryl resin-based bonding agent, or the like is used. Here, the method of fixing the lower metal part 3 to the frame substrate 2 is not particularly limited, and a means other than fixing using a bonding agent may be used.

The lower metal part 3 has a size shorter than the frame substrate 2 in the horizontal direction and has approximately the same size as the frame substrate 2 in the forward/backward direction. The lower metal part 3 is disposed such that a center part of the rear face 2b of the frame substrate 2 in the horizontal direction is coated therewith, and parts of both horizontal sides thereof are exposed.

The lower metal part 3 has an upper face 3a and a lower face 3b that are faces of a horizontal shape. The lower metal part 3 causes the center part of the upper face 3a to face the cavity 8 using the substrate opening part 10. In other words, most of the upper face 3a of the lower metal part 3 is covered with the frame substrate 2, and a portion of the upper face 3a that corresponds to the substrate opening part 10 is exposed and forms a bottom face of the cavity 8. In a portion of the upper face 3a of the lower metal part 3 that is exposed by the substrate opening part 10, the image sensor 4 is mounted. The lower metal part 3 configures a metal-attached substrate 11 that is a member of one body together with the frame substrate 2 (see Fig. 3).

As a metal material forming the lower metal part 3, from the point of view of a heat dissipation property, a material having high thermal conductivity is preferable, and from the point of view of suppressing deformation according to heat, a material having a low linear expansion coefficient is preferable. Examples of the metal material forming the lower metal part 3 include copper (Cu), a copper alloy, tungsten (W), aluminum (Al), stainless steel (SUS), an Fe-Ni-Co alloy, a 42 alloy, and the like.

On the rear face 2b side of the frame substrate 2, a plurality of connectors 12 are disposed as terminals for external connection. The connector 12 is a plug used for electrically connecting the solid-state imaging device 1 to a circuit substrate or the like of an external device. The connector 12 is disposed at two places of exposed parts of both left and right sides of the lower metal part 3 on the rear face 2b side of the frame substrate 2.

The connector 12 has an outer shape of an approximately square column shape having an approximately rectangular shape as its horizontal cross-sectional shape, is disposed in an extending shape in the longitudinal direction of the frame substrate 2, and forms a protrusion portion protruding from the rear face 2b. Two connectors 12 are arranged along edge portions of both left and right sides of the frame substrate 2 and are disposed in parallel with each other. On the rear face 2b side of the frame substrate 2, the lower metal part 3 is disposed between the left and right connectors 12.

The connector 12 has a configuration in which a wiring part such as a lead part made of a metal and the like is disposed at a predetermined portion of a main body part, which is made of a resin, forming the outer shape thereof. The connector 12 has a predetermined fitting shape corresponding to a fitted part receiving fitting of the connector 12. The connector 12 is mounted on the rear face 2b of the frame substrate 2 using soldering or the like such that the wiring part is electrically connected to a wiring portion formed in the frame substrate 2.

In this way, the solid-state imaging device 1 is configured as an image sensor connector package having the connector 12. In addition, the external connection terminal included in the solid-state imaging device 1 is not limited to the connector 12 and may be a pin grid array (PGA) in which a plurality of pins are arranged in a lattice point shape.

The image sensor 4 is disposed in the state of being fixed to the lower metal part 3 and is electrically connected to the frame substrate 2. The image sensor 4 is a semiconductor element including a semiconductor substrate composed of silicon (Si) that is an example of a semiconductor. The image sensor 4 is a rectangular plate-shaped chip and has a front face 4a side that is a plate face of an upper side as a light reception face side and a plate face of the opposite side thereof as a rear face 4b.

In the image sensor 4, the rear face 4b side as the lower metal part 3 side is mounted at a center part of the upper face 3a of the lower metal part 3 by using a die bonding material or the like. The image sensor 4 enters the inside of the substrate opening part 10 to match an opening of the lower side of the substrate opening part 10 formed by the lower side faces 10a of the front, rear, left, and right sides with respect to the substrate opening part 10. In the example illustrated in Fig. 1, the image sensor 4 is disposed such that the front face 4a is positioned on an approximately same plane as the level-difference face 10c forming the substrate opening part 10. Here, a positional relation in a vertical direction between the level-difference face 10c of the substrate opening part 10 and the front face 4a of the image sensor 4 is not particularly limited.

On the front face 4a side of the image sensor 4, a plurality of light reception elements (photoelectric conversion elements) are formed. The image sensor 4 according to this embodiment is an image sensor of a complementary metal oxide semiconductor (CMOS) type. However, the image sensor 4 may be another imaging element such as an image sensor of a charge coupled device (CCD) type or the like.

The image sensor 4, on the front face 4a side, has a pixel area including multiple pixels formed in a predetermined arrangement, for example, such as a Bayer arrangement or the like as a light reception part, and an area on the periphery of the pixel area is set as a peripheral area. In the peripheral area, a predetermined peripheral circuit is formed. The pixel area includes an effective pixel area that generates signal charge, amplifies the signal charge, and reads the signal charge by photoelectric conversion in each pixel. A pixel of the pixel area includes a photodiode as a photoelectric conversion unit having a photoelectric conversion function and a plurality of pixel transistors.

On the front face 4a side of the image sensor 4, in the semiconductor substrate, a color filter and an on-chip lens are formed in correspondence with each pixel through a reflection prevention film formed from an oxide film or the like, a planarization film formed using an organic material, and the like. Light incident in the on-chip lens is received by the photodiode through a color filter, a planarization film, and the like.

Examples of the configuration of the image sensor 4 includes a front side illumination type in which a pixel area is formed on a front face side of a semiconductor substrate, a back side illumination type in which a photodiode and the like are oppositely disposed for improving transmittance of light, and a rear face side of a semiconductor substrate is set as a light reception face side, a type in which a peripheral circuit of a pixel group is stacked as one chip, and the like. However, the image sensor 4 according to the present technology is not limited to these configurations.

The image sensor 4 and the frame substrate 2 are electrically connected to each other using bonding wires 13 as a plurality of connection members (see Fig. 1). The bonding wire 13 connects an electrode formed on the front face 4a of the image sensor 4 and an electrode formed on the frame substrate 2 to each other. In the example illustrated in Fig. 1 and the like, an electrode that becomes a connection part of the bonding wire 13 for the frame substrate 2 is disposed on the level-difference face 10c of the substrate opening part 10. The bonding wire 13, for example, is a thin metallic wire formed from Au (gold) and Cu (copper).

The upper metal part 5 is a metal part disposed on the front face 2a side that is the other plate face of the frame substrate 2. The upper metal part 5 is disposed by fixing a plate-shaped member made of metal on the front face 2a side of the frame substrate 2. The upper metal part 5 has an upper face 5a and a lower face 5b that are faces of horizontal shapes.

A plate-shaped member forming the upper metal part 5 is bonded and fixed to the frame substrate 2, for example, using a die bonding agent that is a resin-based bonding agent. As a bonding agent that fixes the upper metal part 5 to the frame substrate 2, for example, an epoxy resin-based bonding agent, an acryl resin-based bonding agent, or the like is used. However, the method of fixing the upper metal part 5 to the frame substrate 2 is not particularly limited, and a means other than a fixing means using a bonding agent may be used.

In order to allow light received by the image sensor 4 to pass through it, the upper metal part 5 has an opening part 15 that exposes the image sensor 4 in the plan view. The opening part 15 is a hole part going through the upper metal part 5 in a plate thickness direction (a vertical direction) and has an opening shape of a rectangular shape in correspondence with the outer shape of the image sensor 4. The opening part 15 is formed in a rectangular shape at a center part of the upper metal part 5 in the horizontal direction with the forward/backward direction as its longitudinal direction.

The opening part 15 has an opening size that is slightly larger than the outer size of the image sensor 4 and is formed such that the entire image sensor 4 enters the inside of the opening part 15 in the plan view. The opening part 15 of the upper metal part 5 has an opening size that is approximately same as the substrate opening part 10 or much larger than the substrate opening part 10 and is formed such that the substrate opening part 10 and an opening range approximately coincide with each other in the plan view.

The opening part 15 of the upper metal part 5 has an inclination shape in which the opening area is gradually widened from the upper side (the upper face 5a side) to the lower side (the lower face 5b side). In other words, inner faces 15a of front, rear, left, and right sides forming the opening part 15 become inclination faces inclined to be gradually directed from an inner side to an outer side of the upper metal part 5 from the upper side to the lower side. The inner faces 15a inclined in this way, in a side-face cross-sectional view, form corner parts of acute-angle forms together with the upper face 5a of the upper metal part 5 and form corner parts of obtuse-angle forms together with the lower face 5b of the upper metal part 5 (see Fig. 1). In addition, the inner faces 15a forming the opening part 15, for example, may be faces of a vertical form for the upper face 5a.

The inner faces 15a of the opening part 15 become faces that form the cavity 8 in the upper metal part 5. Apart of the front face 2a of the frame substrate 2 on the circumference of the substrate opening part 10 serves as an exposed part 2c that is not covered with the upper metal part 5 in accordance with inclinations of the inner faces 15a and the like, and the exposed part 2c of this front face 2a is included in a face forming the cavity 8.

The upper metal part 5 is formed using the same metal material as that of the lower metal part 3. Thus, similar to the lower metal part 3, as a metal material forming the upper metal part 5, from the point of view of a heat dissipation property, a material having high thermal conductivity is preferable, and, from the point of view of suppressing deformation according to heat, a material having a low linear expansion coefficient is preferable. Examples of the metal material forming the upper metal part 5 include copper (Cu), a copper alloy, tungsten (W), aluminum (Al), stainless steel (SUS), a Fe-Ni-Co alloy, a 42 alloy, and the like. However, the material forming the upper metal part 5 may be a material different from that of the lower metal part 3.

The upper metal part 5 has the opening part 15 and thus has an outer shape of a frame shape. The upper metal part 5 is configured using a metal frame 20 that is a frame-shaped member (see Fig. 3).

The upper metal part 5, in edge portions of both front and rear sides, has protrusion parts 21 of a rectangular shape protruding to both left and right sides. The upper metal part 5 has a middle part in a forward/backward direction as narrow-width parts 22 with respect to front and rear edge portions in which the left and right protrusion parts 21 are formed and has an outer shape of an approximately "H" shape in the plan view. Thus, in the upper metal part 5, in accordance with the protrusion parts 21 and the narrow-width parts 22 on the front and rear sides, concave parts 23 of a rectangular shape are formed on both left and right sides of the middle parts of the front and rear sides.

In the upper metal part 5, the narrow-width parts 22 include vertical side parts 24 forming left and right edge portions of the front and rear middle portions of the opening part 15 (see Fig. 3). In addition, in the upper metal part 5, in front and rear edge portions of the left and right middle portions, horizontal side parts 25 forming front and rear edge portions of the opening part 15 are formed.

The upper metal part 5 has front and rear edge portions, in which the left and right protrusion parts 21 are positioned, to protrude to left and right outer sides with respect to the left and right side faces 2d of the frame substrate 2 in the horizontal direction. On the other hand, the upper metal part 5 has the narrow-width parts 22 to be positioned on left and right inner sides with respect to the left and right side faces 2d of the frame substrate 2 in the horizontal direction. In accordance with the concave part 23, a state in which front and rear middle portions of the left and right edge portions of the front face 2a of the frame substrate 2 are exposed is formed. The upper metal part 5 has an approximately same size as that of the frame substrate 2 in the forward/backward direction.

In the upper metal part 5, in extending portions from the side faces 2d of the frame substrate 2 in protrusion parts 21 of four places, hole parts 26 forming through holes of a circular shape are formed. The hole part 26 is a hole part for fixing that is used for attaching the solid-state imaging device 1 to an external device.

In addition, on the upper face 5a of the upper metal part 5, a reference face 27 used for positioning in attachment of the solid-state imaging device 1 to an external device is formed. The reference face 27 is formed on the circumferences of the hole parts 26 of four places. The reference face 27 is disposed as a face part of a circular shape on the circumferences of the hole parts 26 along the hole shape of the circular shape of the hole parts 26. The reference face 27 is formed as a vertical face with respect to a going-through direction of the hole parts 26. In addition, the position of the solid-state imaging device 1 is determined such that the front face 4a of the image sensor 4 is vertical to the optical axis in an external device.

The connection metal part 6 is a metal part that connects the lower metal part 3 and the upper metal part 5. The connection metal part 6 is positioned in the same layer portion as the frame substrate 2 and thermally connects the lower metal part 3 and the upper metal part 5 disposed respectively in the rear face 2b side and the front face 2a side of the frame substrate 2. In other words, the solid-state imaging device 1, as upper and lower metal layers disposed in a form pinching the frame substrate 2, has the lower metal part 3 and the upper metal part 5 and connects such metal layers using the connection metal part 6.

In this embodiment, the connection metal part 6 is formed integrally with the upper metal part 5. In other words, the connection metal part 6 is disposed as a part of the metal frame 20 that is a metal member of one body. Thus, as illustrated in Fig. 3, the metal frame 20 has a main body frame part 20Athat is a part forming the upper metal part 5 and a connection protrusion part 20B that is a part forming the connection metal part 6.

The connection metal part 6 is a protrusion part of a cylindrical shape that protrudes from the lower face 5b of the upper metal part 5 to the lower side. The connection metal part 6 has an approximately same protrusion size as the plate thickness of the frame substrate 2 and fixes a protrusion tip end side to the lower metal part 3. The connection metal part 6 has a lower end face 6a of a horizontal shape that serves as a connection face (a fixing face) for the upper face 3a of the lower metal part 3 (see Fig. 1). The connection metal part 6 is disposed at left and right two places in left right middle portions of edge portions of both front and rear sides of the upper metal part 5 and is disposed at a total of four places.

In the frame substrate 2, at a place at which the lower metal part 3 and the upper metal part 5 are bonded to each other, as an opening part for positioning the connection metal part 6 in the same layer as the frame substrate 2, a concave part 31 is formed. The concave part 31 becomes a part that exposes the upper face 3a of the lower metal part 3 in the metal-attached substrate 11. The concave part 31 is formed as a through part of a notch shape having a front side or a rear side of the frame substrate 2 as an opening side. In this embodiment, the concave part 31, at an end portion of the inner side in the forward/backward direction, has a wall face shape of a semi-circular arc shape corresponding to the cylinder shape of the connection metal part 6 and has a portion of an outer side in the forward/backward direction as a wall face part along the forward/backward direction.

The concave part 31 is formed at portions of four places corresponding to connection metal parts 6 of four places in the frame substrate 2. In addition, the shape of the opening part of the frame substrate 2 that exposes the upper face 3a for connecting the connection metal part 6 to the lower metal part 3 is not particularly limited, and for example, a hole part of a circular shape may be formed in place of the concave part 31. Furthermore, an outer circumferential face 6b of the connection metal part 6 may be in contact with or spaced from the wall face forming the concave part 31. In addition, a bonding layer using a bonding agent may be interposed between the outer circumferential face 6b of the connection metal part 6 and the wall face forming the concave part 31.

The connection metal part 6 is connected to the upper face 3a of the lower metal part 3 through a connection layer 33 formed from a thermally conductive material (see Fig. 1). The connection layer 33 is interposed between the connection metal part 6 and the lower metal part 3 in full scale with respect to the lower end face 6a of the connection metal part 6. Examples of the terminal of the connection layer 33 are a thermal interface material (TIM) material to which a filler is added for raising thermal conductivity and a die bonding material having relatively high thermal conductivity. In addition, the connection layer 33 may be a metal film.

The glass 7 is disposed to block the opening part 15 on the upper face 5a side that is a side opposite to the frame substrate 2 side with respect to the upper metal part 5. The glass 7 is an example of a transparent member serving as an optical window, has an outer shape of a rectangular plate shape, and has an upper face 7a and a lower face 7b both of which are faces of right-side a horizontal shape.

The glass 7 is disposed on the upper metal part 5 and is disposed being in parallel with and being separated by a predetermined gap from the image sensor 4 on a light reception side of the image sensor 4. The glass 7 has a much larger outer shape size than the outer shape of the opening part 15 of the upper metal part 5 in the plan view. By fixing the lower face 7b to the upper metal part 5 using a bonding agent or the like as a contact face for the upper face 5a of the upper metal part 5, the glass 7 covers the entire opening part 15 from the upper side, seals the circumference of the opening part 15, and tightly closes the opening part 15.

In this way, on the upper side of the image sensor 4, the glass 7 is disposed to face the front face 4a of the image sensor 4 through the substrate opening part 10 and the opening part 15 of the upper metal part 5. The glass 7 forms the cavity 8 that is a space of a tightly-closed form together with the frame substrate 2, the lower metal part 3, and the upper metal part 5.

The glass 7 allows various types of light incident from optical systems such as a lens and the like that are generally positioned on the upper side thereof. The light transmitted through the glass 7 is incident in a light reception face of the image sensor 4 through the cavity 8. The glass 7 has a function of protecting a light reception face side of the image sensor 4 and has a function of blocking penetration of a moisture (steam), dusts, and the like into the inside of the cavity 8 from the outside together with the upper metal part 5. In addition, as a transparent member according to the present technology, in place of the glass 7, for example, a plastic plate or a silicon plate or the like that allows only infrared light to pass through it can be used.

In the solid-state imaging device 1 having the configuration as described above, light that has passed through the glass 7 passes through the inside of the cavity 8 and is received and detected by a light reception element configuring each pixel disposed in a pixel area of the image sensor 4.

An example of attachment of the solid-state imaging device 1 in an external device will be described with reference to Fig. 6. As illustrated in Fig. 6, in an external device such as a camera or the like, the solid-state imaging device 1 is attached to a casing 50 that supports a lens unit 40 as an optical system including a plurality of lenses 41.

The lens unit 40 images light from a subject at the image sensor 4 using the plurality of lenses 41. The lens unit 40 has a support cylinder 42 configured in a cylindrical shape and supports the plurality of lenses 41 inside the support cylinder 42. In the example illustrated in Fig. 6, the support cylinder 42 has a cylinder axis direction to be directed along the direction of an optical axis L1 of the lens unit 40 and supports three lenses 41 in a state of being stacked in a vertical direction through a spacer or the like. The optical axis L1 of the lens unit 40 is a straight line of a vertical direction passing through the center of the three lenses 41. In addition, the number of lenses 41 is not particularly limited.

The casing 50, for example, has side wall parts 51 of all the front, rear, left and right sides and is configured as a member of a frame shape to an angular cylinder shape such that an opening part 51a that opens both upper and lower sides in accordance with such side wall parts 51 is formed. The opening part 51a is open in a range including the entire image sensor 4 in the plan view and forms a space portion used for allowing light received by the image sensor 4 through the lens unit 40 to pass through it.

The casing 50 has a lens unit supporting face 52 to which the lens unit 40 is attached on the upper side. The lens unit supporting face 52, for example, is formed as a flat face vertical to the vertical direction in accordance with upper faces of the side wall parts 51 of front, rear, left, and right sides.

The lens unit 40 has a lower face of the support cylinder 42 as an attachment face 43 that is a flat face vertical to the vertical direction with respect to the lens unit supporting face 52 of the casing 50. The lens unit 40 is disposed such that, on the casing 50, an optical axis direction is a direction vertical to the plate face of the image sensor 4 (the vertical direction). The lens unit 40 is mounted on the casing 50 in a state in which the attachment face 43 of the support cylinder 42 is fixed on the lens unit supporting face 52 of the casing 50 using an adhesive agent or the like. The lens 41 is disposed in parallel with the image sensor 4 on the upper side of the image sensor 4.

The casing 50 has a package attaching face 53 to which the solid-state imaging device 1 is attached on the lower side. The package attaching face 53, for example, is formed as a flat face that is vertical to the vertical direction in accordance with the lower face of the side wall parts 51 of the front, rear, left, and right sides.

The solid-state imaging device 1 is fixed to the casing 50 using the upper face 5a of the upper metal part 5 as an attachment face that is a flat face vertical to the vertical direction with respect to the package attaching face 53 of the casing 50. The casing 50 is disposed in the state of being in contact with a peripheral edge portion of the upper face 5a of the upper metal part 5 using the package attaching face 53 that causes the lower side of the opening part 51a to be opened.

The solid-state imaging device 1 is fastened using four screws 35 as fastening tools with the upper face 5a of the upper metal part 5 set as a contact face for the package attaching face 53 by using the hole parts 26 of four places formed in the upper metal part 5, thereby being fixed to a predetermined position with respect to the casing 50. The screws 35 go through the hole parts 26 of the upper metal part 5 from the lower side and are screwed into screw holes 51b that are opened for the package attaching face 53 in the casing 50.

In attachment of the solid-state imaging device 1 to the casing 50, the reference face 27 formed on the upper face 5a of the upper metal part 5 is operated. The reference face 27 is brought into contact with a reference face (not illustrated) of the casing 50 side formed to face the package attaching face 53 of the casing 50 in accompaniment with the solid-state imaging device 1 being fastened in the casing 50 using the screws 35, thereby positioning the solid-state imaging device 1 with respect to the casing 50. The solid-state imaging device 1 is positioned through the casing 50 with respect to the lens unit 40 such that the front face 4a of the image sensor 4 is vertical to the optical axis L1.

In this embodiment, although the solid-state imaging device 1 is fixed to the casing 50 at four places using the screws 35 using the hole parts 26 of the upper metal part 5 as fastening hole parts, the method of fixing the solid-state imaging device 1 to the casing 50 is not particularly limited. In fixation of the solid-state imaging device 1 to the casing 50, for example, a fixing member such as an adhesive agent or the like may be used.

In the configuration in which the solid-state imaging device 1 is set with respect to the lens unit 40 through the casing 50, light condensed by a plurality of lenses 41 passes through the glass 7 and is incident in the light reception face of the image sensor 4 through the cavity 8.

### <2. Method of Manufacturing Solid-State Imaging Device According to First Embodiment>

One example of a method of manufacturing the solid-state imaging device 1 according to the first embodiment of the present technology will be described with reference to Fig. 7.

In the method of manufacturing the solid-state imaging device 1, as illustrated in Fig. 7A, a process of preparing a metal-attached substrate 11 is performed. The metal-attached substrate 11 can be acquired by bonding a metal plate forming the lower metal part 3 to the rear face 2b side of the frame substrate 2 using brazing, a resin, or the like. In the metal-attached substrate 11, a connector 12 is mounted as an external terminal. In addition, in the frame substrate 2, a concave part 31 is formed as a part for bonding the lower metal part 3 and the upper metal part 5 to each other.

Next, as illustrated in Fig. 7B, an image sensor 4 is mounted in the metal-attached substrate 11. The image sensor 4 can be acquired as a sensor chip by individualizing a silicon wafer formed in a state in which sensor parts are two-dimensionally connected through dicing. The image sensor 4 is set at a predetermined position through chip mounting or the like for a part exposed from the substrate opening part 10 of the upper face 3a of the lower metal part 3 and is die-bonded using a die bonding agent.

As illustrated in Fig. 7B, after the image sensor 4 is mounted, a process of disposing a bonding wire 13 electrically connecting the image sensor 4 and the frame substrate 2 is performed. Here, a plurality of electrode pads disposed on the front face 4a side of the image sensor 4 and a plurality of wiring parts disposed at predetermined places in the frame substrate 2 are electrically connected to each other by connecting wires using the bonding wire 13. The bonding wire 13, for example, is wired to form a predetermined shape that is convex toward the upper side such as an arch shape or the like.

As above, the image sensor 4 is in a state of being fixed to the frame substrate 2 through the lower metal part 3 and being electrically connected to the frame substrate 2.

Next, as illustrated in Fig. 7C, a process of disposing the upper metal part 5 on the front face 2a side of the frame substrate 2 is performed. In other words, a process of mounting the metal frame 20 on the frame substrate 2 is performed.

By fixing the connection protrusion part 20B serving as the connection metal part 6 to the upper face 3a exposed by the concave part 31 using a thermal conduction adhesive agent such as a TIM material or the like, the metal frame 20 is fixed to the metal-attached substrate 11.

The metal frame 20 is frame-mantled on the frame substrate 2 by a predetermined mounter in a state in which the upper face 3a of the inside of the concave part 31 or an end face (the lower end face 6a) of the connection protrusion part 20B is coated with a thermal conduction adhesive agent, and, a process of curing the thermal conduction adhesive agent, for example, a heating process (curing) or the like is performed. In accordance with this, a state in which the metal frame 20 and the lower metal part 3 are bonded together through a connection layer 33 in which the thermal conduction adhesive agent is cured is formed, and a state in which the upper metal part 5 and the connection metal part 6 are disposed in accordance with the main body frame part 20A and the connection protrusion part 20B is formed.

In a frame mounting process in which the metal frame 20 is mounted on the frame substrate 2, for example, a device configuration as below is used. The metal-attached substrate 11, for example, is supported by a jig device that can move along an X axis, a Y axis, and a Z axis that are orthogonal to each other and is disposed to be able to rotate around such three axes. In addition, the metal frame 20, for example, in a mounter, is supported by a support face part of which a degree of flatness is assured. Here, positioning of the metal frame 20, hole parts 26 as parts through which a support pin passes are used. In addition, an imaging device such as a CCD camera or the like for imaging the image sensor 4 mounted in the metal-attached substrate 11 that is in the state of being set in the jig device is used.

In such a device configuration, for example, in the following order, the metal frame 20 is mounted. First, the metal-attached substrate 11 in which the image sensor 4 is mounted is fixed to a jig device, and the metal frame 20 is supported by a mounter. Next, the upper face 3a of the lower metal part 3 exposed by the concave part 31 of the frame substrate 2 is coated with a thermal conduction adhesive agent such as a TIM material or the like. In addition, a tip end of the connection protrusion part 20B of the metal frame 20 may be coated with the thermal conduction adhesive agent. Next, by using image recognition according to an image acquired by imaging the image sensor 4 using the imaging device, the position of the jig device is adjusted, and position matching between the metal-attached substrate 11 and the metal frame 20 is performed such that the front face 4a of the image sensor 4 and the upper face 5a of the metal frame 20 are in parallel with each other.

Then, while the positional relation between the metal-attached substrate 11 and the metal frame 20, the metal frame 20 is mounted on the frame substrate 2 in accordance with movement or the like of the jig device, and a state in which the connection protrusion part 20B is brought into contact with the upper face 3a of the lower metal part 3 through the thermal conduction adhesive agent is formed. Thereafter, a process of curing the thermal conduction adhesive agent is performed.

After the frame mounting process, as illustrated in Fig. 7D, a glass sealing process in which the glass 7 is attached on the upper metal part 5 is performed. The glass 7, for example, can be acquired by cutting a glass plate having a predetermined shape into rectangular shapes through dicing.

The glass 7 is bonded and fixed to the upper face 5a of the upper metal part 5 using an adhesive agent or the like such that it covers the entire opening part 15 from the upper side. For example, in a case in which the adhesive agent has a thermosetting property, in a state in which the glass 7 is mounted on the upper metal part 5 through the adhesive agent, a heating process for curing the adhesive agent (curing) is performed. By attaching the glass 7, a cavity 8 is formed on the upper side of the image sensor 4. According to the manufacturing process described above, the solid-state imaging device 1 is acquired.

According to the solid-state imaging device 1 of this embodiment as described above, a good heat dissipation property can be acquired using a simple configuration, and adjustment of tilting of the image sensor 4 can be easily performed with high accuracy. In other words, according to the solid-state imaging device 1, both a heat dissipation property for heat generated from the image sensor 4 serving as a heat dissipation body and an advantage of adjustment of tilting of the image sensor 4 can be achieved, and a package structure having high heat dissipation and high accuracy can be acquired.

Relating to the heat dissipation property, in the solid-state imaging device 1, the image sensor 4 is directly mounted in the lower metal part 3 disposed on the rear face 2b side of the frame substrate 2, and the lower metal part 3 is connected to the upper metal part 5 disposed on the front face 2a side of the frame substrate 2 through the connection metal part 6. According to such a configuration, relating to heat generated by the image sensor 4, heat dissipation of the frame substrate 2 to the lower side using the lower metal part 3 is secured, and heat dissipation to the upper side of the frame substrate 2 is secured using the upper metal part 5 connected to the lower metal part 3 through the connection metal part 6.

Thus, heat of the image sensor 4 is transferred to the upper metal part 5 through the lower metal part 3 and the connection metal part 6, and thus the heat of the image sensor 4 can be caused to diffuse to both sides including the front face 2a side and the rear face 2b side of the frame substrate 2, and thus a good heat dissipation property can be acquired. In this way, according to the solid-state imaging device 1, heat dissipation paths can be provided on both face sides of the frame substrate 2 while securing an electric signal path, and thus heat of the image sensor 4 can be released to both upper and lower sides through the frame substrate 2, and thus the heat dissipation property can be improved.

In addition, according to the solid-state imaging device 1, by employing a simple configuration in which the lower metal part 3 in which the image sensor 4 is mounted and the upper metal part 5 are connected using the connection metal part 6, and the frame substrate 2 is interposed between the upper and lower metal parts, a good heat dissipation property can be acquired. Furthermore, as in the solid-state imaging device 1 according to this embodiment, by including a configuration in which the upper metal part 5 is used as a support part of the glass 7 and a configuration in which the connection metal part 6 is disposed within the range of the outer shape of the rectangular shape of the frame substrate 2, a compact configuration can be realized.

Relating to adjustment of tilting of the image sensor 4, in the method of manufacturing the solid-state imaging device 1 described above, by using the following method, adjustment of tilting of the image sensor 4 can be easily performed with high accuracy. In other words, there is a method in which tilting of the image sensor 4 is adjusted using the upper face 5a that is an upper face of the metal frame 20 configuring the upper metal part 5 as a reference face.

More specifically, by using a laser microscope, a laser length measuring device, or the like or using a signal from the image sensor 4 at the time of performing die bonding of the image sensor 4 for the metal-attached substrate 11, the inclination (tilting) of the front face 4a serving as an imaging face (a light reception face) of the image sensor 4 is measured. While the measurement result is fed back, the metal frame 20 is mounted with respect to the metal-attached substrate 11.

In the process of frame mounting of the metal frame 20, by using the reference face 27 of the upper metal part 5, the inclination of the metal frame 20 with respect to the frame substrate 2 is adjusted such that the reference face 27 is in parallel with the front face 4a of the image sensor 4, and the metal frame 20 is bonded to the lower metal part 3 using a thermal conduction adhesive agent such as a TIM material or the like. In accordance with this, a state in which the front face 4a of the image sensor 4 and the upper face 5a of the upper metal part 5 are in parallel with each other is acquired. In addition, the adjustment of the inclination of the metal frame 20 with respect to the frame substrate 2, for example, is performed by adjusting the amount of a thermal conduction adhesive agent such as a TIM material or the like.

For example, as illustrated in Fig. 6, when the solid-state imaging device 1 is mounted in the lens unit 40 through the casing 50, the position of a package as the solid-state imaging device 1 is determined with respect to the casing 50 using the reference face 27. In accordance with this, a state in which the front face 4a of the image sensor 4 is vertical to the optical axis L1 of the lens unit 40 is acquired. In this way, in the method of manufacturing the solid-state imaging device 1, a process of adjusting the degree of parallelization of the metal frame 20 with respect to the image sensor 4 mounted in the lower metal part 3 can be performed.

In addition, in the method of manufacturing the solid-state imaging device 1 described above, the following method can be used. In other words, there is a method in which adjustment of tilting of the metal frame 20 configuring the upper metal part 5 is performed using the upper face 3a of the lower metal part 3 in the metal-attached substrate 11 as a reference face.

More specifically, by using a laser microscope, a laser length measuring device, or the like, the inclination (tilting) of the upper face 3a of the lower metal part 3 in the metal-attached substrate 11 is measured. In the measurement of the inclination of the upper face 3a of the lower metal part 3, a portion of the upper face 3a that is exposed by the concave part 31 of the frame substrate 2 is used. While a measurement result of the inclination of the upper face 3a is fed back, the metal frame 20 is mounted with respect to the metal-attached substrate 11.

In the process of frame mounting of the metal frame 20, by using the reference face 27 of the upper metal part 5, the inclination of the metal frame 20 with respect to the lower metal part 3 is adjusted such that the reference face 27 is in parallel with the upper face 3a of the lower metal part 3, and the metal frame 20 is bonded to the lower metal part 3 using a TIM material or the like. In the adjustment of the inclination of the metal frame 20 with respect to the lower metal part 3, for example, adjustment of a position in the direction of each axis of an X axis, a Y axis, and a Z axis that are orthogonal to each other and a position in the rotation direction (a rotation angle) around each axis as its center is performed. In accordance with this, a state in which the upper face 3a of the lower metal part 3 and the upper face 5a of the upper metal part 5 are in parallel with each other is acquired.

For example, in a case in which the degree of parallelization between the lower metal part 3 and the upper metal part 5 is low, a deviation occurs in the layer thickness of the connection layer 33 used for bonding the upper metal part 5 to the lower metal part 3 through the connection metal part 6, and a portion of which a layer thickness is relatively large is generated. An increase in the layer thickness of the connection layer 33 becomes a cause reducing thermal conduction from the lower metal part 3 to the upper metal part 5.

Thus, according to the method of performing adjustment of the tilting of the metal frame 20 with respect to the lower metal part 3 as described above, the metal frame 20 can be mounted in the lower metal part 3 with high accuracy, and a state in which the lower metal part 3 and the upper metal part 5 are in parallel with each other can be formed. In accordance with this, the layer thickness of the connection layer 33 can be configured to be thin, and the heat dissipation property from the lower metal part 3 to the connection metal part 6 and the upper metal part 5 can be improved, whereby a high heat dissipation property can be acquired in the solid-state imaging device 1. In this way, in the method of manufacturing the solid-state imaging device 1, the process of adjusting the degree of parallelization of the metal frame 20 with respect to the lower metal part 3 can be performed.

In addition, in the solid-state imaging device 1, the connection metal part 6 is integrally formed with the upper metal part 5 in the metal frame 20. According to such a configuration, the connection metal part 6 does not need to be disposed as a separate component, thus the number of components can be decreased, and the process of manufacturing the solid-state imaging device 1 can be simplified. In addition, the connection metal part 6 becomes a part integrated with the upper metal part 5, and thus a good thermal conduction property between the connection metal part 6 and the upper metal part 5 can be acquired, and thus the heat dissipation property can be improved in the configuration having the lower metal part 3 and the upper metal part 5, and a good heat dissipation property can be acquired in the solid-state imaging device 1.

In addition, in the solid-state imaging device 1, it is preferable that the lower metal part 3 and the upper metal part 5 be formed using the same metal material. According to such a configuration, in the lower metal part 3 and the upper metal part 5, for example, physical properties such as linear expansion coefficients and the like of both metal parts can be configured to match each other, and thus a bonding state of both the metal parts formed through the connection metal part 6 can be easily maintained. In accordance with this, a good heat dissipation property according to the lower metal part 3 and the upper metal part 5 can be easily secured.

In addition, in the solid-state imaging device 1, the upper metal part 5 is configured using the metal frame 20 that is a member of an integrated frame shape. According to such a configuration, on the front face 2a side of the frame substrate 2, by employing a simple configuration, the upper metal part 5 can be provided while securing an incident path of light for the image sensor 4.

In addition, in the solid-state imaging device 1, the upper metal part 5 has the opening part 15 used for securing an incident path of light for the image sensor 4, and the glass 7 sealing the opening part 15 is disposed on the upper metal part 5. According to such a configuration, the upper metal part 5 can be used as a part supporting the glass 7 on the upper side of the image sensor 4. In accordance with this, as a package structure of the solid-state imaging device 1, a simple and compact configuration can be realized.

### <3. Modified Example of Solid-State Imaging Device According to First Embodiment>

Modified examples of the solid-state imaging device 1 according to the first embodiment of the present technology will be described. Among modified examples to be described above, first to third modified examples are modified examples relating to the connection metal part 6, and a fourth modified example is a modified example relating to the frame substrate 2.

### (First modified example)

As illustrated in Fig. 8, in the first modified example, the connection metal part 6 is integrally formed with the lower metal part 3. In other words, the connection metal part 6 is disposed as a part of a plate-shaped member 130 forming the lower metal part 3. Thus, the plate-shaped member 130 has a main body plate part 130A that is a part forming the lower metal part 3 and a connection protrusion part 130B that is a part forming the connection metal part 6.

In the first modified example, the connection metal part 6 fixes an upper end face 6d of a horizontal shape of the protrusion tip end side to the lower face 5b of the upper metal part 5 through the connection layer 33 formed from a thermal conductive material such as a TIM material, a die bonding member, or the like. The connection layer 33 is interposed between the connection metal part 6 and the upper metal part 5 in full scale with respect to the upper end face 6d of the connection metal part 6. In this way, the connection metal part 6 may be a part protruding toward the upper metal part 5 side from the lower metal part 3.

### (Second modified example)

As illustrated in Fig. 9, in the second modified example, the connection metal part 6 is formed by a member that is separate from the lower metal part 3 and the upper metal part 5. In other words, the connection metal part 6 is disposed by fixing a column-shaped member 140 made of metal having an outer shape of a cylinder to both the lower metal part 3 and the upper metal part 5. Thus, the column-shaped member 140 is interposed between plate-shaped members forming the lower metal part 3 and the upper metal part 5.

In the second modified example, the connection metal part 6 respectively fixes the lower end face 6a and the upper end face 6d to the upper face 3a of the lower metal part 3 and the lower face 5b of the upper metal part 5 through a connection layer 33 formed from a thermal conductive material such as a TIM material, a die bonding member, or the like. From the point of view of obtaining a good thermal conduction property between the lower metal part 3 and the upper metal part 5, it is preferable that a metal material forming the column-shaped member 140 be the same as a material forming the lower metal part 3 and the upper metal part 5. In this way, the connection metal part 6 may be a part that is disposed by fixing a member that is separate from members forming the lower metal part 3 and the upper metal part 5.

### (Third modified example)

As illustrated in Fig. 10, in the third modified example, a connection metal part 6 is disposed as a part of a plate shape. In the example illustrated in Fig. 10, the connection metal part 6 is integrally formed with the upper metal part 5. In other words, the connection metal part 6 is disposed as a part of the metal frame 20. Thus, as illustrated in Fig. 10, the metal frame 20 has a main body frame part 20A that is a part forming the upper metal part 5 and a connection plate part 20C that is a part forming the connection metal part 6.

The connection metal part 6 is a protrusion part of a rectangular plate shape protruding from the lower face 5b of the upper metal part 5 to the lower side. The connection metal part 6 has a forward/backward direction as its plate thickness direction and has a leftward/rightward direction as its longitudinal direction. The connection metal part 6 has an approximately same protrusion size as the plate thickness of the frame substrate 2 and fixes the protrusion tip end side to the lower metal part 3. The connection metal part 6 has a lower end face 6e of a horizontal shape serving as a connection face (fixing face) for the upper face 3a of the lower metal part 3. The connection metal part 6 is disposed in a horizontal middle part along edge portions of both front and rear sides of the upper metal part 5.

In the frame substrate 2, in both front and rear edge portions that are places at which the lower metal part 3 and the upper metal part 5 are bonded, as opening parts for positioning the connection metal part 6 and the frame substrate 2 in the same layer, concave parts 131 are formed. The concave parts 131 are parts that expose the upper face 3a of the lower metal part 3 in the metal-attached substrate 11. The concave parts 131 are formed as parts of a notch shape having the front side or the rear side of the frame substrate 2 as an opening side. The concave part 131 forms a notch shape of a rectangular shape using a wall face part extending in the horizontal direction in correspondence with an outer shape of the connection metal part 6 of a rectangular plate shape and side wall face parts disposed on both left and right sides of this wall face part.

The connection metal part 6 fixes the lower end face 6e with respect to the upper face 3a of the lower metal part 3 through a connection layer formed from a thermal conductive material such as a TIM material, a die bonding material, or the like. The connection layer interposes the lower end face 6e of the connection metal part 6 between the connection metal part 6 and the lower metal part 3 in full scale. In this way, the connection metal part 6 may be a part that is disposed as a part of a plate shape. Also in the third modified example, the connection metal part 6, as in the first modified example, may be a part integrally formed with the lower metal part 3 or, as in the second modified example, may be a part formed using a member that is a body separate from the lower metal part 3 and the upper metal part 5.

### (Fourth modified example)

As illustrated in Fig. 11, in the fourth modified example, a substrate opening part 10 of the frame substrate 2 is formed as an opening part having no level-difference shape. In other words, the frame substrate 2 has side faces 10d of four sides continuous over the entire frame substrate 2 in a thickness direction as faces forming the substrate opening part 10. The side faces 10d are faces vertical to the front face 2a and the rear face 2b of the frame substrate 2.

In this way, in the configuration in which the frame substrate 2 has the substrate opening part 10 that has no level difference, an electrode serving as a connection part of the bonding wire 13 for the frame substrate 2 is disposed at a position near the side face 10d on the front face 2a of the frame substrate 2. In the configuration in which one end side of the bonding wire 13 is connected to the front face 2a of the frame substrate 2, compared to a case in which the substrate opening part 10 has a level-difference shape as illustrated in Fig. 1 and the like, a height difference between faces to which both ends of the bonding wire 13 are connected becomes large, and thus the bonding wire 13 is formed to be raised (see Fig. 11). In other words, a wiring shape that is convex toward the upper side forming the bonding wire 13 becomes a relatively large convex shape. In this way, the frame substrate 2 may have the configuration in which the substrate opening part 10 having no level-difference is included. This modified example, for example, is appropriately used in a case in which the frame substrate 2 is an organic substrate.

Also according to the configurations of various modified examples described above, as described above, a good heat dissipation property and an advantage of adjustment of tilting of the image sensor 4 can be obtained using a simple configuration. The shape, the arrangement positions, the number of arrangement places, and the like of the connection metal part 6 are not limited to those of the modified examples described above, and various aspects may be employed. The shape of the connection metal part 6, for example, may be a rectangular column shape, a half-circle shape, a spindle shape, or the like. In addition, the arrangement positions of the connection metal part 6, for example, may be positions of both left and right sides of the vertical side parts 24 or the like in the metal frame 20. Furthermore, the shape of the side face part forming the substrate opening part 10 in the frame substrate 2 is not particularly limited and, for example, may be a curved shape, an inclined shape, a level-difference shape of a plurality of levels, or the like.

### <4. Configuration Example of Solid-State Imaging Device According to Second Embodiment>

A configuration example of a solid-state imaging device 61 according to a second embodiment of the present technology will be described with reference to Figs. 12 to 15. Fig. 12 is a cross-sectional view corresponding to a B - B position illustrated in Fig. 13. In each embodiment described below, the same reference sign will be assigned to components that are common or corresponding to the first embodiment to have the same name, and description of duplicate details will be appropriately omitted.

As illustrated in Figs. 12 to 15, the solid-state imaging device 61 according to this embodiment includes a resin frame part 62 as a resin part disposed on a side (an upper side) opposite to a frame substrate 2 side with respect to an upper metal part 65 as a second metal part. The resin frame part 62 is formed using a resin as its material and configures a resin metal frame 70 that is a member of a frame shape together with the upper metal part 65 configured using a metal frame that is a member of a frame shape (see Fig. 15).

The resin metal frame 70 has a two-layer structure including the upper metal part 65 and the resin frame part 62. In other words, in the resin metal frame 70, the upper metal part 65 serves as a lower layer part, and, on the upper side of the upper metal part 65, the resin frame part 62 as an upper layer part is disposed.

The resin frame part 62 is disposed in the state of being fixed to an upper face 65a of the upper metal part 65. The resin frame part 62 is a part of a flat plate shape as a whole and has an upper face 62a and a lower face 62b that are faces of a horizontal shape.

In order to pass light received by an image sensor 4, the resin frame part 62 has an opening part 63 that exposes the image sensor 4 in the plan view. The opening part 63 is a hole part going through the resin frame part 62 in a plate thickness direction (a vertical direction) and has an opening shape of a rectangular shape in correspondence with the outer shape of the image sensor 4. The opening part 63 has an approximately same opening size as the opening part 15 of the upper metal part 65, is formed such that the opening part 15 and an opening range approximately coincide with each other in the plan view, and is disposed to be vertically continuous to the opening part 15. The opening part 63 is formed in a rectangular shape at a center part of the upper metal part 5 in the horizontal direction with a forward/backward direction set as its longitudinal direction.

Similar to the opening part 15 of the upper metal part 5 according to the first embodiment, the opening part 63 of the resin frame part 62 has an inclined shape in which the opening area is gradually widened from the upper side to the lower side. In other words, inner faces 63a of front, rear, left, and right sides forming the opening part 63 become inclined faces that are inclined to face the inner side to the outer side of the upper metal part 5 gradually from the upper side to the lower side. In addition, the inner faces 63a forming the opening part 63, for example, may be faces of a vertical shape with respect to the upper face 62a of the resin frame part 62. In addition, in the example illustrated in Fig. 12, in the upper metal part 65, the inner faces 15a forming the opening part 15 become faces of a vertical shape with respect to the upper face 65a. The inner faces 15a of the opening part 15 of the upper metal part 65 and the inner faces 63a of the opening part 63 of the resin frame part 62 become faces forming a cavity 8 in the resin metal frame 70.

By having the opening part 63, the resin frame part 62 has an outer shape of a frame shape. The resin frame part 62 has approximately the same shape/size as those of the upper metal part 5 according to the first embodiment. The resin frame part 62, in edge portions of both front and rear sides, has protrusion parts 71 of a rectangular shape protruding to both left and right sides. The resin frame part 62 has an outer shape of an approximate "H" shape in the plan view by forming concave parts 73 of a rectangular shape on both left and right sides of a middle portion of the front and rear sides using the middle portion in the forward/backward direction as narrow width parts 72 for front and rear edge portions in which the left and right protrusion parts 71 are formed. The resin frame part 62 has vertical side parts 74 forming left and right edge portions of the front-rear middle portion of the opening part 63 and horizontal side parts 75 forming front and rear edge portions of the opening part 63.

In this embodiment, hole parts for fixing that are used for attachment of the solid-state imaging device 61 to an external device are formed in the resin frame part 62. In the resin frame part 62, in extending portions from side faces 2d of the frame substrate 2 in the protrusion parts 71 of four places, boss parts 76 having hole parts 76a forming through holes of a circular shape are formed. The boss parts 76 are parts of a cylindrical shape having a vertical direction as a cylinder axis direction and protrude to upper and lower sides with respect to the upper face 62a and the lower face 62b of the resin frame part 62.

In the boss part 76, an opening end face of an upper side serves as a reference face 77 used for positioning in the attachment of the solid-state imaging device 61 to an external device. The reference face 77 is formed on an upper side of the boss parts 76 of four places. The reference face 77 is disposed as a face part of an annular shape along the circular hole shapes of the hole parts 76a. The reference face 77 is formed as a face vertical to the going-through direction of the hole part 76a.

In this embodiment, the upper metal part 65 is in contact with the boss parts 76 with end faces 21a of left and right outer sides of the protrusion parts 21 formed on four corners used as contact faces for outer circumferential faces 76b of the boss parts 76. The end faces 21a are faces that are along the forward/backward direction in the plan view and have a vertical shape with respect to the upper face 65a. In addition, the upper metal part 65 may be disposed not to be in contact with the boss parts 76.

The resin metal frame 70 can be acquired by disposing a resin frame part 62 in a metal frame that is a plate-shaped metal member forming the upper metal part 65 through resin molding such as injection molding or the like. In a case in which injection molding is used, in a state in which a metal frame forming the upper metal part 65 is set in a metal mold for molding, a resin material that is in a melted state is injected into the inside of a molding space of the metal mold, and predetermined processing such as heating, cooling, or the like is performed on a resin material filled in the molding space, whereby the resin material is cured. In accordance with this, a resin part that becomes the resin frame part 62 is formed. However, the resin metal frame 70 may be manufactured by integrating a resin frame prepared in advance as a member forming the resin frame part 62 and a metal frame forming the upper metal part 65 through bonding using an adhesive agent or the like.

The resin material forming the resin frame part 62 is not particularly limited and, for example, is an epoxy-based resin or the like. In addition, as a resin material forming the resin frame part 62, from the point of view of preventing reflection of light, for example, a low-reflection black resin material acquired by adding a black pigment such as carbon black, titanium black, or the like to a resin such as a liquid crystal polymer, polyether ether ketone (PEEK), or the like is used.

In the example illustrated in Fig. 12, similar to the first modified example of the first embodiment described above, the connection metal part 6 is integrally formed with the lower metal part 3. However, the connection metal part 6 may be either a part formed integrally with the upper metal part 5 (see Fig. 1) or a part formed by a member of a body separate from the lower metal part 3 and the upper metal part 5 (see Fig. 9).

The glass 7 is disposed to block the opening part 63 on the upper face 62a side that is a side opposite to the frame substrate 2 side with respect to the resin frame part 62. The glass 7 is disposed on the resin frame part 62 and thus is disposed being in parallel with and being separated by a predetermined gap from the image sensor 4.

The glass 7 has a much larger outer shape size than the outer shape of the opening part 63 of the resin frame part 62 in the plan view. By fixing the lower face 7b to the resin frame part 62 using a bonding agent or the like as a contact face for the upper face 62a of resin frame part 62, the glass 7 covers the entire opening part 63 from the upper side, seals the circumference of the opening part 63, and tightly closes the opening part 63.

In this way, on the upper side of the image sensor 4, the glass 7 is disposed to face the front face 4a of the image sensor 4 through the substrate opening part 10, the opening part 15 of the upper metal part 5, and the opening part 63 of the resin frame part 62. The glass 7 forms the cavity 8 that is a space of a tightly-closed form together with the frame substrate 2, the lower metal part 3, the upper metal part 5, and the resin frame part 62.

According to the solid-state imaging device 61 of this embodiment as described above, in addition to the operations and the effects acquired by the solid-state imaging device 1 according to the first embodiment and the manufacturing method thereof, operations and effects as below can be acquired.

In the solid-state imaging device 61, on an upper side of the upper metal part 65, a resin frame part 62 configuring the resin metal frame 70 is disposed together with the upper metal part 65. According to such a configuration, compared to a configuration in which the entire metal frame 20 is formed using metal, the weight of the frame (the resin metal frame 70) used for providing the upper metal part 65 can be configured to be light, and thus a light weight of the package structure can be achieved. In accordance with this, as illustrated in Fig. 6, a light weight of a set configuration in which the solid-state imaging device 61 is attached to the lens unit 40 through the casing 50 can be achieved. In addition, in accordance with achievement of a light weight of the solid-state imaging device 61, a weight applied to a fastening portion of the solid-state imaging device 61 for the casing 50 can be decreased, and thus a strength required for the fastening portion can be easily secured.

In addition, by disposing the resin frame part 62 on the upper side of the upper metal part 65 and disposing the boss parts 76 that are fastening portions of an external device in the resin frame part 62, the hole parts 76a as fastening holes and the reference face 77 can be formed with high accuracy. In accordance with this, adjustment of tilting of the image sensor 4 as described above can be performed with high accuracy.

For example, since the hole parts 26 of the metal frame 20 are formed through drilling or the like for metal, deformation and the like of holes occur, and thus there is room for improvement in the aspect of accuracy. Thus, by forming the hole parts for fastening in a resin part by providing the resin frame part 62, high accuracy of the fastening portion can be realized through resin molding.

In addition, by configuring fastening portions of the solid-state imaging device 61 for an external device to be the boss parts 76 of a cylindrical shape, the strength of the fastening portions can be improved. Here, like the hole parts 26 according to the first embodiment, the hole parts for fastening formed in the resin frame part 62 may be formed in portions of a flat plate shape.

In addition, according to the configuration in which the upper metal part 65 is disposed on the lower side of the resin frame part 62, a heat dissipation path from the resin frame part 62 to the upper metal part 65 can be formed, and thus a heat dissipation property from the resin frame part 62 can be improved.

Furthermore, by disposing the resin frame part 62 on the upper side of the frame substrate 2 and configuring this part as support parts for the glass 7, the glass 7 can be bonded and fixed to the resin portion. In accordance with this, for example, compared to a case in which the glass 7 is bonded and fixed to a metal portion, differences between the glass 7 and a bonding target in the linear expansion coefficient and the elastic modulus can be reduced, and thus improvement of reliability of the glass 7 for bonding can be achieved.

In addition, according to the configuration in which the resin frame part 62 is disposed on the upper metal part 65, as a part supporting the glass 7 on the upper side of the image sensor 4, the resin frame part 62 can be used. In accordance with this, as a package structure of the solid-state imaging device 61, a simple and compact configuration can be realized.

As described above, the solid-state imaging device 61 has a frame configuration disposed on the upper side of the frame substrate 2 to be the resin metal frame 70 of a hybrid type of a metal having a high heat dissipation property and a resin that can be molded with high accuracy. In accordance with this, the solid-state imaging device 61 has a package structure in which fastening holes for an external device have high accuracy with the frame configuration light-weighted.

### <5. Configuration Example of Solid-State Imaging Device According to Third Embodiment>

A configuration example of a solid-state imaging device 81 according to a third embodiment of the present technology will be described with reference to Figs. 16 to 18. Fig. 16 is a cross-sectional view corresponding to a C - C position illustrated in Fig. 17. In addition, the same reference signs will be assigned to components that are common to the second embodiment, and description of duplicate details will be appropriately omitted.

As illustrated in Figs. 16 to 18, the solid-state imaging device 81 according to this embodiment includes a surface metal part 85 as a third metal part, which is different from the solid-state imaging device 61 according to the second embodiment. In other words, the solid-state imaging device 81 includes the surface metal part 85 disposed on a side (an upper side) opposite to an upper metal part 65 side with respect to a resin frame part 62. The surface metal part 85 configures a double-sided metal resin frame 90 that is a member of a frame shape together with the upper metal part 65 and the resin frame part 62 (see Fig. 18).

The double-sided metal resin frame 90 has a three-layer structure of the upper metal part 65, the resin frame part 62, and the surface metal part 85 and has a sandwich structure in which the resin frame part 62 is interposed between upper and lower metal parts. In other words, in the double-sided metal resin frame 90, the upper metal part 65 becomes a lower layer part, the resin frame part 62 forming a base of the double-sided metal resin frame 90 is disposed on the upper side of the upper metal part 65, and the surface metal part 85 as an upper layer part is disposed on the upper side of the resin frame part 62.

The surface metal part 85 is disposed on an upper face 62a of the resin frame part 62 in a fixed state. The surface metal part 85 is a part of a flat plate shape as a whole and has an upper face 85a and a lower face 85b that are faces of a horizontal shape.

In order to avoid an interference with the glass 7, the surface metal part 85 has an opening part 86 having an opening size that is slightly larger than an outer shape of the glass 7 in the plan view. The opening part 86 is a hole part going through the surface metal part 85 in a plate thickness direction (a vertical direction) and has an opening shape of a rectangular shape in correspondence with an outer shape of the glass 7.

Inner faces 86a of four sides forming the opening part 86 of the surface metal part 85 are faces of a vertical shape with respect to the upper face 85a of the surface metal part 85. The surface metal part 85 has each of the inner faces 86a of the opening part 86 to face a side face 7c of the glass 7. In other words, the surface metal part 85 is disposed to expose a circumferential portion of the opening part 63 to which the glass 7 is bonded in the upper face 62a of the resin frame part 62 in the plan view in accordance with the opening part 86.

The surface metal part 85 has approximately same shape/size as the upper metal part 65 and is disposed to overlap approximately the whole upper metal part 65 in the plan view. The surface metal part 85, in edge portions of both front and rear sides, has protrusion parts 91 of a rectangular shape protruding to both left and right sides. The surface metal part 85 has middle portions in a forward/backward direction as narrow-width parts 92 for the edge portions of the front and rear sides in which the left and right protrusion parts 91 are formed, forms concave parts 93 of a rectangular shape on both left and right sides of the middle portions of the front and rear sides, and has an outer shape of approximately "H" in the plan view. The surface metal part 85 has vertical side parts 94 forming edge portions of left and right sides of the front and rear middle portions of the opening part 86 and horizontal side parts 95 forming edge portions of the front and rear sides of the opening part 86.

In addition, in this embodiment, the surface metal part 85 is brought into contact with the boss parts 76 with end faces 91a of left and right outer sides of the protrusion parts 91 formed on four corners as contact faces for outer circumferential faces 76b of the boss parts 76. The end face 91a is a face that is along a forward/backward direction in the plan view and has a vertical shape with respect to the upper face 85a. In addition, the surface metal part 85 may be disposed not to be in contact with the boss parts 76.

The double-sided metal resin frame 90 can be acquired by disposing a resin frame part 62 in a metal frame that is a plate-shaped metal member forming each of the upper metal part 65 and the surface metal part 85 through resin molding such as injection molding or the like. In a case in which injection molding is used, in a state in which a metal frame forming the upper metal part 65 is set on the lower side, and a metal frame forming the surface metal part 85 is set on the upper side with respect to a mold for molding, a resin material that is in a melted state is injected into the inside of a molding space of the metal mold, and predetermined processing such as heating, cooling, or the like is performed on a resin material filled in the molding space, whereby the resin material is cured. In accordance with this, a resin part that becomes the resin frame part 62 is formed. However, the double-sided metal resin frame 90 may be manufactured by integrating a resin frame prepared in advance as a member forming the resin frame part 62 and metal frames respectively forming the upper metal part 65 and the surface metal part 85 through bonding using an adhesive agent or the like.

The surface metal part 85, for example, is formed using the same metal material as the lower metal part 3 and the upper metal part 65. However, the material forming the surface metal part 85 may be different from the material forming the lower metal part 3 and the upper metal part 65.

According to the solid-state imaging device 81 of this embodiment as described above, in addition to the operations and the effects acquired by the solid-state imaging device 61 according to the second embodiment, the following operations and effects can be acquired.

In the solid-state imaging device 81, on the upper side of the resin frame part 62, the surface metal part 85 configuring the double-sided metal resin frame 90 together with the upper metal part 65 and the resin frame part 62 is disposed. According to such a configuration, compared to a configuration in which the entire metal frame 20 is formed using metal, the weight of the frame (the double-sided metal resin frame 90) used for providing the upper metal part 65 can be configured to be light, and thus a light weight of the package structure can be achieved.

In addition, according to a configuration in which the upper metal part 65 is disposed on the lower side of the resin frame part 62, and the surface metal part 85 is disposed on the upper side of the resin frame part 62, heat dissipation paths from the resin frame part 62 to both upper and lower sides can be formed using the upper metal part 65 and the surface metal part 85, and thus the heat dissipation property from the resin frame part 62 can be effectively improved.

As described above, the solid-state imaging device 81 has a frame configuration disposed on the upper side of the frame substrate 2 to be the double-sided metal resin frame 90 of a hybrid type in which both upper and lower sides of a resin that can be molded with high accuracy is formed using a metal having high heat dissipation property. In accordance with this, the solid-state imaging device 81 has a package structure in which fastening holes for an external device have high accuracy, and a heat dissipation property from the resin frame part is improved with the frame configuration light-weighted.

### <6. Configuration Example of Solid-State Imaging Device According to Fourth Embodiment>

A configuration example of a solid-state imaging device 101 according to a fourth embodiment of the present technology will be described with reference to Figs. 19 to 21. Fig. 19 is a cross-sectional view corresponding to a D - D position illustrated in Fig. 20. In addition, the same reference signs will be assigned to components that are common to the embodiments described above, and description of duplicate details will be appropriately omitted.

As illustrated in Figs. 19 to 21, in the solid-state imaging device 101 according to this embodiment, a connection metal part 106 connecting a lower metal part 3 and an upper metal part 65 together is extended to the upper side, and a double-sided metal resin frame 90 is configured to go through it, which is different from the solid-state imaging device 81 according to the third embodiment. In other words, in the solid-state imaging device 101, the connection metal part 106 is integrally formed with the lower metal part 3, and protrusion parts 107 that go through a frame substrate 2 and protrude from the upper metal part 65 to a side (an upper side) opposite to the frame substrate 2 side are included.

The connection metal part 106 is a post part of a cylindrical shape protruding from an upper face 3a of the lower metal part 3 to the upper side and has an upper end face 106a of a horizontal shape. The connection metal part 106 goes through the frame substrate 2 and the double-sided metal resin frame 90 disposed on the upper side thereof and has the upper end face 106a to have the same face shape as an upper face 85a of a surface metal part 85.

In other words, a protrusion length of the connection metal part 106 from the upper face 3a of the lower metal part 3 is the same or approximately the same as a size of a sum of a plate thickness of the frame substrate 2 and a plate thickness (a layer thickness) of the upper metal part 65, the resin frame part 62, and the surface metal part 85 configuring the double-sided metal resin frame 90. Thus, a size of a protrusion part 107 in the vertical direction that is a part protruded from the upper face 65a of the upper metal part 65 to the upper side in the connection metal part 106 is the same or approximately the same as a size of a sum of plate thicknesses of the resin frame part 62 and each part of the surface metal part 85. In addition, the connection metal part 106 may protrude from the upper face 85a of the surface metal part 85 to the upper side, or the upper end face 106a may be positioned on the lower side of the upper face 85a.

In the double-sided metal resin frame 90, at a place through which the connection metal part 106 goes through, a hole part 96 going though in the vertical direction is formed. The hole part 96 is a part in which opening parts formed in respective parts of the upper metal part 65, the resin frame part 62, and the surface metal part 85 forming a three-layer structure of the double-sided metal resin frame 90 are vertically continuous. The hole part 96 has a hole shape forming a circular shape in the plan view and has an inner diameter that is approximately the same as an outer diameter of the connection metal part 106 of a cylindrical shape. The hole part 96 is formed to be vertically continuous to the concave part 31 of the frame substrate 2.

The connection metal part 106 is thermally connected to at least the upper metal part 65 and the surface metal part 85 for a layer structure configuring the double-sided metal resin frame 90. The connection metal part 106 may have an outer circumferential face 106b to be in contact with an inner circumferential face of the hole part 96 of the double-sided metal resin frame 90, or a connection layer formed from a thermal conductive material may be interposed between the connection metal part 106 and the inner circumferential face of the hole part 96.

A configuration in which the outer circumferential face 106b of the connection metal part 106 is brought into contact with the inner circumferential face of the hole part 96 of the double-sided metal resin frame 90 can be acquired, for example, by pressing the connection metal part 106 into the hole part 96. In such a configuration, the outer circumferential face 106b of the connection metal part 106, for example, is in the state of being in contact with inner circumferential faces 65d, 62d, and 85d of the upper metal part 65, the resin frame part 62, and the surface metal part 85 forming the hole part 96 (see Fig. 21). In addition, the outer circumferential face 106b may be in contact with only a part of the inner circumferential face of the hole part 96.

In addition, as a material of the connection layer interposed between the outer circumferential face 106b of the connection metal part 106 and the inner circumferential face of the hole part 96 of the double-sided metal resin frame 90, similar to the connection layer 33 described above, for example, a TIM material to which a filler for raising thermal conductivity has been added or the like is used. By fixing the connection metal part 106 to the double-sided metal resin frame 90 using the connection layer, the strength of the package structure for bending and the like of the double-sided metal resin frame 90 can be improved. In addition, the connection layer may be interposed only between the outer circumferential face 106b of the connection metal part 106 and a part of the inner circumferential face of the hole part 96.

According to the solid-state imaging device 101 of this embodiment as described above, in addition to the operations and the effects acquired by the solid-state imaging device 81 according to the third embodiment, the following operations and effects can be acquired.

In the solid-state imaging device 101, the connection metal part 106 that is integrally formed with the lower metal part 3 is disposed to extend such that it is thermally connected to each layer of the double-sided metal resin frame 90. According to such a configuration, relating to heat generated by the image sensor 4, heat dissipation of the frame substrate 2 to the lower side using the lower metal part 3 is secured, and heat dissipation of the frame substrate 2 to the upper side is secured using the upper metal part 65 and the surface metal part 85.

Thus, heat of the image sensor 4 is transferred to the upper metal part 65 and the surface metal part 85 through the lower metal part 3 and the connection metal part 106, whereby the heat of the image sensor 4 can diffuse on the front face 2a side and the rear face 2b side of the frame substrate 2 and the upper face 62a of the resin frame part 62. In accordance with this, a heat dissipation property from the image sensor 4 can be effectively improved.

In addition, in this embodiment, although the connection metal part 106 is integrally formed with the lower metal part 3, extends to the upper side, and is connected to the upper metal part 65 and the surface metal part 85, the formation aspect of the connection metal part 106 is not particularly limited. As a configuration relating to the connection metal part 106, for example, as illustrated in Fig. 22, a configuration in which the connection metal part 106 as a part integrally formed with the surface metal part 85 extends from the lower face 85b to the lower side, and the connection metal part 106 is connected to the upper metal part 65 and the lower metal part 3 may be employed.

In the configuration illustrated in Fig. 22, the connection metal part 106 is integrally formed with the surface metal part 85, goes through the resin frame part 62, the upper metal part 65, and the frame substrate 2, and is connected to the lower metal part 3. In the example illustrated in Fig. 22, the connection metal part 106 has protrusion parts 108 protruding from the frame substrate 2 to the lower side. The connection metal part 106 goes through the lower metal part 3 and has the lower end face 106d to be the same face shape as the lower face 3b of the lower metal part 3.

### <7. Configuration Example of Solid-State Imaging Device According to Fifth Embodiment>

A configuration example of a solid-state imaging device 121 according to a fifth embodiment of the present technology will be described with reference to Figs. 23 to 25. Fig. 23 is a cross-sectional view corresponding to a E - E position illustrated in Fig. 24. In addition, the same reference signs will be assigned to components that are common to the third embodiment, and description of duplicate details will be appropriately omitted.

As illustrated in Figs. 23 to 25, in the solid-state imaging device 121 according to this embodiment, an upper metal part 65 and a surface metal part 85 are connected using a metal part, which is different from the solid-state imaging device 81 according to the third embodiment. In other words, the solid-state imaging device 121 includes a second connection metal part 126 as a second connection part that is a metal part connecting the upper metal part 65 and the surface metal part 85 together. The second connection metal part 126 configures a double-sided metal resin frame 150 that is a member of a frame shape together with the upper metal part 65, a resin frame part 62, and the surface metal part 85 (see Fig. 25).

The second connection metal part 126 is a post part of a cylindrical shape connecting the upper metal part 65 and the surface metal part 85 and is disposed at a plurality of places. The second connection metal part 126 is integrally formed with each of the upper metal part 65 and the surface metal part 85. In other words, the upper metal part 65 and the surface metal part 85 are connected to each other using a plurality of second connection metal parts 126 and configures a metal frame of one body together with the plurality of second connection metal parts 126.

In the example illustrated in Fig. 24, the second connection metal parts 126 are disposed at six places in one row in a leftward/rightward direction in edge portions of both front and rear sides of the double-sided metal resin frame 150 with a predetermined interval and are disposed at six places in one row in a forward/backward direction in the vertical side parts 94 of left and right sides of the surface metal part 85 with a predetermined interval, and thus are disposed at a total of 24 places. In addition, the second connection metal parts 126 of four places positioned near four corners of the glass 7 are disposed on the same axial center as that of the connection metal part 6. However, the shape/size, the number, and arrangement positions of the second connection metal parts 126 are not particularly limited.

The resin frame part 62 is positioned in the same layer as the second connection metal parts 126 and thus has hole part 62e allowing the second connection metal parts 126 to go through it. As a hole diameter of the hole part 62e is approximately the same as an outer diameter of the second connection metal part 126, and an outer circumferential face 126a of the second connection metal part 126 is in contact with an inner circumferential face of the hole part 62e. However, the second connection metal part 126 may be spaced apart from the inner circumferential face of the hole part 62e.

The double-sided metal resin frame 150 can be acquired by disposing the resin frame part 62 in a metal frame that is a metal member of one body acquired by connecting the upper metal part 65 and the surface metal part 85 using a plurality of the second connection metal parts 126 through resin molding such as injection molding or the like. In this metal frame, a space portion in which a plurality of second connection metal parts 126 are disposed is formed between the upper metal part 65 and the surface metal part 85 spaced away by a predetermined gap in parallel with each other. The space portion between the upper metal part 65 and the surface metal part 85 is one space portion that is continuous in a metal frame and is open over the entire circumference of the metal frame in accordance with the arrangement form of the plurality of second connection metal parts 126 spaced away from each other.

In a case in which injection molding is used in formation of the resin frame part 62, in a state in which a metal frame forming the upper metal part 65, the surface metal part 85, and the plurality of second connection metal parts 126 is set in a metal mold for molding, a resin material that is in a melted state is injected into the inside of a molding space of the metal mold. Here, the resin material is filled in a space portion between the upper metal part 65 and the surface metal part 85 that becomes a molding space. Thereafter, by performing predetermined processing such as heating, cooling, or the like on the resin material, the resin material is cured. In accordance with this, a resin portion that becomes the resin frame part 62 is formed.

According to the solid-state imaging device 121 of this embodiment as described above, in addition to the operations and the effects acquired by the solid-state imaging device 81 according to the third embodiment, the following operations and effects can be acquired.

The solid-state imaging device 121 has a configuration in which the upper metal part 65 and the surface metal part 85 forming the double-sided metal resin frame 150 are connected using the plurality of second connection metal parts 126. According to such a configuration, heat dissipation paths from the resin frame part 62 to both upper and lower sides can be formed using the upper metal part 65 and the surface metal part 85, and a heat dissipation path from the inner circumferential face side of the hole part 62e of the resin frame part 62 can be formed using the plurality of second connection metal parts 126. In accordance with this, a heat dissipation property from the resin frame part 62 can be effectively improved.

In addition, in this embodiment, although the second connection metal part 126 is integrally formed with both the upper metal part 65 and the surface metal part 85, the formation aspect of the second connection metal part 126 is not particularly limited. The second connection metal part 126 may be a part that is integrally formed with only one of the upper metal part 65 and the surface metal part 85 or may be a part formed by a member that is separate from both the upper metal part 65 and the surface metal part 85.

In a case in which the second connection metal part 126 is formed by a member that is a body separate from at least one of the upper metal part 65 and the surface metal part 85, the second connection metal part 126, for example, is directly in contact with a metal part that is a body separate from the second connection metal part 126 or is connected thereto through a connection layer formed from a thermal conductive material.

In addition, the second connection metal part 126 may be a part that thermally connects the upper metal part 65 and the surface metal part 85 to each other, and the formation aspect is not limited to this embodiment. The second connection metal parts 126, for example, may be a plurality of parts of a wall shape or may be a continuous integral part of a wall shape forming a rectangular frame shape in the plan view.

The second connection metal part 126, for example, is formed using the same metal material as that of the upper metal part 65 and the surface metal part 85. However, the material forming the second connection metal part 126 may be a material different from that of the upper metal part 65 and the surface metal part 85.

### <8. Configuration Example of Electronic Device>

An application example of the solid-state imaging device according to the embodiments described above to an electronic device will be described with reference to Fig. 26.

The solid-state imaging device according to the present technology can be applied to general electronic devices using a solid-state imaging element in an image capturing unit (a photoelectric conversion unit) such as a camera device including a digital still camera, a video camera, and the like, a portable terminal device that has an imaging function, a copy machine using a solid-state imaging element in an image reading unit, and the like. The solid-state imaging device may be formed as a one-chip or may be formed as a module in which an imaging unit and a signal processing unit or an optical system are collectively packaged with an imaging function.

As illustrated in Fig. 26, a camera device 200 as an electronic device includes an optical unit 202, a solid-state imaging device 201, a digital signal processor (DSP) circuit 203 that is a camera signal processing circuit, a frame memory 204, a display unit 205, a recording unit 206, an operation unit 207, and a power supply unit 208. The DSP circuit 203, the frame memory 204, the display unit 205, the recording unit 206, the operation unit 207, and the power supply unit 208 are connected to one another via a connection line 209 such as a bus line or the like. The solid-state imaging device 201 is any one of the solid-state imaging devices according to the embodiments described above.

The optical unit 202 including a plurality of lenses captures incident light (image light) from a subject and forms an image on an imaging surface of the solid-state imaging device 201. The solid-state imaging device 201 converts the amount of incident light, which is formed into an image on the imaging surface by the optical unit 202, into an electric signal for each pixels and outputs the electric signal as a pixel signal.

The display unit 205, for example, is formed from a panel-type display device such as a liquid crystal panel or an organic EL (Electro Luminescence) panel and displays a moving image or a still image captured by the solid-state imaging device 201. The recording unit 206 records the moving image or the still image captured by the solid-state imaging device 201 in a recording medium, e.g., a hard disk or a semiconductor memory.

The operation unit 207 issues operation commands for various functions included in the camera device 200 under a user's operation. The power supply unit 208 appropriately supplies various power supplies serving as operation power supplies for the DSP circuit 203, the frame memory 204, the display unit 205, the recording unit 206, and the operation unit 207 to these supply targets.

According to the camera device 200 as described above, relating to the solid-state imaging device 201, a good heat dissipation property can be acquired using a simple configuration, and adjustment of tilting of the image sensor 4 can be easily performed with high accuracy. In accordance with this, a good operation state can be maintained in the camera device 200, and desired characteristics can be acquired.

The description of the embodiment described above is an example of the present technology, and the present technology is not limited to the foregoing embodiments. For this reason, it is needless to say that various changes aside from the foregoing embodiment can be made according to the design and the like without departing from the technical idea of the present disclosure. In addition, the advantages described in the present disclosure are merely exemplary and not limited, and other advantages may be obtained. The configurations of the embodiment and the modified examples can be combined as appropriate.

The present technology can be used in a wide range as a countermeasure for heat dissipation of a component-mounted module product.

The present technology can have the following configurations.
(1) A semiconductor device including: a substrate; a first metal part configured to be disposed on one plate face side of the substrate; a semiconductor element configured to be disposed in a state of being fixed to the first metal part and electrically connected to the substrate; a second metal part configured to be disposed on the other plate face side of the substrate; and a connection part that is a metal part connecting the first metal part and the second metal part to each other.
(2) The semiconductor device described in (1) described above, in which the connection part is integrally formed with the second metal part.
(3) The semiconductor device described in (1) or (2) described above, in which the first metal part and the second metal part are formed using the same metal material.
(4) The semiconductor device described in any one of (1) to (3) described above, in which the second metal part is configured by a member of a frame shape.
(5) The semiconductor device described in any one of (1) to (4) described above, in which the second metal part has an opening part exposing the semiconductor element, and the semiconductor device further includes a transparent member configured to be disposed to close the opening part on a side opposite to the substrate side with respect to the second metal part and form a cavity that is a space of a closed shape together with the substrate, the first metal part, and the second metal part.
(6) The semiconductor device described in any one of (1) to (5) described above, further including a resin part configured to be disposed on a side opposite to the substrate side with respect to the second metal part, be formed using a resin as a material, and configure a member of a frame shape together with the second metal part.
(7) The semiconductor device described in (6) described above, in which the second metal part and the resin part each have an opening part exposing the semiconductor element, and the semiconductor device further includes a transparent member configured to be disposed to close the opening part on a side opposite to the substrate side with respect to the resin part and form a cavity that is a space of a closed shape together with the substrate, the first metal part, the second metal part, and the resin part.
(8) The semiconductor device described in (6) or (7) described above, further including a third metal part configured to be disposed on a side opposite to the second metal part side with respect to the resin part and configure a member of a frame shape together with the second metal part and the resin part.
(9) The semiconductor device described in (8) described above, further including a second connection part that is a metal part connecting the second metal part and the third metal part to each other.
(10) The semiconductor device described in any one of (1) to (9) described above, in which the connection part has a protrusion part that is integrally formed with the first metal part, goes through the substrate, and protrudes from the second metal part to a side opposite to the substrate side.
(11) An electronic device including a semiconductor device including: a substrate; a first metal part configured to be disposed on one plate face side of the substrate; a semiconductor element configured to be disposed in a state of being fixed to the first metal part and electrically connected to the substrate; a second metal part configured to be disposed on the other plate face side of the substrate; and a connection part that is a metal part connecting the first metal part and the second metal part to each other.

### [Reference Signs List]

1 Solid-state imaging device (semiconductor device)
2 Frame substrate (substrate)
2a Front face (the other plate face)
2b Rear face (one plate face)
3 Lower metal part (first metal part)
4 Image sensor (semiconductor element)
5 Upper metal part (second metal part)
6 Connection metal part (connection part)
7 Glass (transparent member)
8 Cavity
15 Opening part
20 Metal frame
62 Resin frame part (resin part)
63 Opening part
65 Upper metal part (second metal part)
70 Resin metal frame
85 Surface metal part (third metal part)
90 Double-sided metal resin frame
106 Connection metal part (connection part)
107 Protrusion part
126 Second connection metal part (second connection part)
150 Double-sided metal resin frame
200 Camera device (electronic device)

## Claims

1. A semiconductor device comprising:
a substrate;
a first metal part configured to be disposed on one plate face side of the substrate;
a semiconductor element configured to be disposed in a state of being fixed to the first metal part and electrically connected to the substrate;
a second metal part configured to be disposed on the other plate face side of the substrate; and
a connection part that is a metal part connecting the first metal part and the second metal part to each other.

2. The semiconductor device according to claim 1, wherein the connection part is integrally formed with the second metal part.

3. The semiconductor device according to claim 2, wherein the first metal part and the second metal part are formed using the same metal material.

4. The semiconductor device according to claim 1, wherein the second metal part is configured by a member of a frame shape.

5. The semiconductor device according to claim 1, wherein the second metal part has an opening part exposing the semiconductor element,
the semiconductor device further comprising a transparent member configured to be disposed to close the opening part on a side opposite to the substrate side with respect to the second metal part and form a cavity that is a space of a closed shape together with the substrate, the first metal part, and the second metal part.

6. The semiconductor device according to claim 1, further comprising a resin part configured to be disposed on a side opposite to the substrate side with respect to the second metal part, be formed using a resin as a material, and configure a member of a frame shape together with the second metal part.

7. The semiconductor device according to claim 6, wherein the resin part has an opening part exposing the semiconductor element,
the semiconductor device further comprising a transparent member configured to be disposed to close the opening part on a side opposite to the substrate side with respect to the resin part and form a cavity that is a space of a closed shape together with the substrate, the first metal part, the second metal part, and the resin part.

8. The semiconductor device according to claim 6, further comprising a third metal part configured to be disposed on a side opposite to the second metal part side with respect to the resin part and configure a member of a frame shape together with the second metal part and the resin part.

9. The semiconductor device according to claim 8, further comprising a second connection part that is a metal part connecting the second metal part and the third metal part to each other.

10. The semiconductor device according to claim 1, wherein the connection part has a protrusion part that is integrally formed with the first metal part, goes through the substrate, and protrudes from the second metal part to a side opposite to the substrate side.

11. An electronic device comprising a semiconductor device including:
a substrate;
a first metal part configured to be disposed on one plate face side of the substrate;
a semiconductor element configured to be disposed in a state of being fixed to the first metal part and electrically connected to the substrate;
a second metal part configured to be disposed on the other plate face side of the substrate; and
a connection part that is a metal part connecting the first metal part and the second metal part to each other.
